# EUROPÄISCHE PATENTANMELDUNG

(11) **EP 4 531 117 A1**
(43) Veröffentlichungstag der Anmeldung: **02.04.2025**
(21) Anmeldenummer: 23199793.3
(22) Anmeldetag: 26.09.2023
(51) Int. Cl.: H01L 31/107, H01L 31/18, H01L 27/146

(54) **VERFAHREN ZUR ERZEUGUNG TIEFLIEGENDER P-N-ÜBERGÄNGE IN EINEM BCD-PROZESS, BCD-SUBSTRAT UND DARAUF BASIERENDE EINZELPHOTONEN-LAWINENDIODE**

(71) Anmelder: Elmos Semiconductor SE, 44227 Dortmund (DE)
(72) Erfinder: Rotter, Thomas, 91077 Neunkirchen am Brand (DE); Kölbel, Julia, 44137 Dortmund (DE)
(74) Vertreter: Gulde & Partner

(57) **Zusammenfassung**

Gegenstand der vorliegenden Erfindung ist ein Verfahren zur Erzeugung tiefliegender p-n-Übergänge (50, 52, 54a, 54b, 56a, 56b) in einem BCD-Prozess und eine darauf basierende Einzelphotonen-Lawinendiode (engl. "single-photon avalanche diode, SPAD"). Das Verfahren umfasst ein Bereitstellen eines Trägersubstrats (10); ein Einbringen eines ersten Dotierstoffs (20) zur Ausbildung eines ersten Gebiets (22) vom ersten Leitungstyp in eine Oberfläche (S) des Trägersubstrats (10); ein Einbringen eines zweiten Dotierstoffs (30) zur Ausbildung eines zweiten Gebiets (32) vom zweiten Leitungstyp in die Oberfläche (S) des Trägersubstrats (10), wobei sich das erste Gebiet (22) und das zweite Gebiet (32) zumindest teilweise überlagern; und ein Aufwachsen einer epitaktischen Schicht (40) auf die Oberfläche (S) des Trägersubstrats (20), wobei sich das erste Gebiet (22) und das zweite Gebiet (32) durch Diffusion des ersten Dotierstoffs (20) und des zweiten Dotierstoffs (30) in der epitaktischen Schicht (40) ausbreiten, wobei das Diffusionsverhalten des ersten und des zweiten Dotierstoffs (20, 30) derart gewählt sind, dass der erste und zweite Dotierstoff (20, 30) durch Diffusion einen in der epitaktischen Schicht (40) liegenden p-n-Übergang (50, 52, 54a, 54b, 56a, 56b) ausbilden.

## Beschreibung

### Gegenstand der Erfindung

Die vorliegende Erfindung betrifft ein Verfahren zur Erzeugung tiefliegender p-n-Übergänge in einem BCD-Prozess, ein BCD-Substrat mit einem tiefliegenden p-n-Übergang und eine darauf basierende Einzelphotonen-Lawinendiode (engl. "single-photon avalanche diode, SPAD"), insbesondere ein Verfahren zur Ausbildung eines tiefliegenden p-n-Übergangs durch Einbringen oder Diffusion der Dotierstoffe im Grenzbereich zwischen einem Trägersubstrat und einer auf eine Oberfläche des Trägersubstrats aufgewachsenen epitaktischen Schicht. Der erfindungsgemäß bereitgestellte p-n-Übergang kann vorteilhaft als tiefliegender p-n-Übergang für eine isolierte, in BCD-Technologie hergestellte SPAD genutzt werden.

### Technologischer Hintergrund

Zum Aufbau von integrierten Schaltungen in der Bipolar-CMOS-DMOS-Technologie (BCD-Technologie) werden typischerweise Substrate mit tiefliegenden Schichten (engl. "buried layer, BL") vom ersten und/oder zweiten Leitungstyp (NBL, PBL) benötigt. Die zu deren Erzeugung genutzten Dotierstoffe werden dabei in der Regel durch Implantation in ein Trägersubstrat eingebracht. Anschließend wird die entsprechende Oberfläche im Allgemeinen mit einer epitaktischen Schicht (EPI-Schicht) zur weiteren Prozessierung überwachsen. Die im BCD-Substrat bereitgestellten tiefliegenden dotierten Schichten können direkt als Bestandteil einer darüber angeordneten integrierten Schaltung verwendet werden. Die Schichten können auch zur Isolation und Abschirmung einer integrierten Schaltung gegenüber dem Trägersubstrat dienen.

Im Stand der Technik sind verschiedene Techniken zur Erzeugung tiefliegender n- und p-dotierter Schichten in einem BCD-Prozess bekannt. Insbesondere können zum selektiven Einbringen von entsprechenden Dotierstoffen zur Ausbildung von NBL- und PBL-Schichten zunächst lithographisch über eine erste Maske ein erstes Gebiet vom ersten Leitungstyp und anschließend über eine zweite Maske ein zweites Gebiet vom zweiten Leitungstyp erzeugt werden. Der Abstand der NBL- und PBL-Schichten zueinander ist dabei prozesstechnisch vorgegeben. Die Dotierstoffe werden über entsprechend strukturierte Maskenöffnungen flach in die Oberfläche des Trägersubstrats eingebracht und diffundieren dann aus. Beim Aufwachsen der EPI-Schicht kommt es durch die hohen Temperaturen beim Prozessieren zu einer weiteren Diffusion der Dotierstoffe (engl. "dopant redistribution"), bis diese feste Plätze im umgebenden Material eingenommen haben und somit weitgehend definierte Gebiete ausbilden können. Die NBL- und PBL-Schichten werden im Stand der Technik üblicherweise nebeneinander erzeugt, wobei die Dicke dieser Gebiete im Wesentlichen durch das Diffusionsverhalten der jeweiligen Dotierstoffe bestimmt ist.

Ein Anwendungsbeispiel für eine integrierte Schaltung auf Basis solcher BCD-Substrate mit tiefliegenden n- und p-dotierten Schichten sind integrierte Einzelphotonen-Lawinendioden (engl. "single-photon avalanche diodes, SPADs"). Hierbei handelt es sich um eine Art Photodetektor ähnlich den Photodioden und Avalanche-Photodioden, jedoch mit einer demgegenüber deutlich erhöhten Sensitivität. Wird eine solche integrierte Schaltung optisch angeregt, so werden durch die von außen in den sensorisch aktiven Bereich des Halbleitermaterials (Absorptionsgebiet) eingebrachten Photonen dort Elektron-Loch-Paare generiert, wobei die angeregten Elektronen durch elektrische Felder zur Kathode und die angeregten Löcher zur Anode abgezogen werden. Dabei driften die Ladungsträger auch durch ein sogenanntes Lawinengebiet, innerhalb dessen durch eine verstärkte Stoßionisation eine Ladungslawine erzeugt werden kann.

Eine SPAD wird typischerweise im Geiger-Modus betrieben, wobei ein einzelnes Photon über die erzeugte Ladungslawine detektiert wird und anschließend als Einzelereignis registriert wird. Zur Verringerung der während der Registrierung auftretenden Totzeit kann unmittelbar nach dem Einsetzen der Lawinenausbildung eine aktive oder passive Unterdrückung der weiteren Ladungsträgerverstärkung erfolgen. Die integrierte Schaltung kann neben der SPAD auch ein sogenanntes Einzelphotonenzählwerk bzw. einen Einzelphotonenzähler (engl. "single-photon counter") umfassen, hierbei erfolgt im Allgemeinen anstatt der Ausgabe eines einzelnen Detektorimpulses eine unmittelbare statistische Auswertung der zeitlichen Verteilung der einzelnen Einzelphotonendetektionsereignisse.

Es wird zwischen nSPADs und pSPADs unterschieden. Die Begriffe nSPAD und pSPAD dienen dabei zur Kennzeichnung dafür, welche Art der Ladungsträger überwiegend für die Ausbildung der Stoßionisation, d. h. für die Lawinenausbildung in der SPAD, verantwortlich ist. Bei einer nSPAD sind dies insbesondere die negativ geladenen Elektronen, während bei einer pSPAD vor allem die positiv geladenen Löcher für die Lawinenausbildung verantwortlich sind. Häufig werden pSPADs realisiert, da bei diesen eine schaltungstechnisch einfache Lowside-Auslesung erfolgen kann. nSPADs sind jedoch wegen der höheren Lawinenwahrscheinlichkeit und damit der typischerweise höheren Photonendetektionseffizienz (PDE) bevorzugt. Normalerweise liegt bei nSPADs das Lawinengebiet nahe an der Oberfläche des Substrats, es gibt jedoch auch invertierte Anordnungen bei denen das Lawinengebiet tiefer im Substrat angeordnet ist. Bei der Implementierung von SPAD-Imagern ("SPAD-Arrays") ist bei einem Wechsel vom pSPAD- zum nSPAD-Design typischerweise auch ein Wechsel von der Lowsidezu einer Highside-Auslesung notwendig. Dies ist schaltungstechnisch zwar möglich, aber wesentlich komplexer für den Bereich der SPAD-Imager.

In BCD-Technologien mit normaler nicht-invertierter nSPAD-Struktur gemäß Stand der Technik ist die effektive Nachweistiefe bei der Absorption von eindringenden Photonen in die integrierte Schaltung (d. h. die Absorptionstiefe) nur gering. Insbesondere können Elektronen, welche weit unterhalb des nSPAD-Lawinengebiets im Substrat generiert werden, nicht mehr die Kathode (n-dotiertes Gebiet) an der Oberfläche des BCD-Substrats erreichen. Aufgrund der daraus resultierenden verminderten Absorptionstiefe, ergibt sich ein entsprechend geringer Nutzstrom bzw. eine kleine Effektivität im nahinfraroten Spektralbereich (NIR). Durch das Einbringen einer hoch dotierten tiefliegenden Schicht unterhalb einer herkömmlichen nSPAD-Struktur kann dieser Nutzstrom jedoch erhöht werden, indem die effektiv wirksame Nachweistiefe von Photonen erhöht wird. Insbesondere wird der Nutzstrom dadurch erhöht, dass der oberhalb der tiefliegenden Schicht befindliche Bereich zusätzliche getrennte Ladungsträger zur Lawinenerzeugung bereitstellen kann (siehe z. B. Gramuglia, Francesco, et al. "Engineering breakdown probability profile for PDP and DCR optimization in a SPAD fabricated in a standard 55 nm BCD process." IEEE Journal of Selected Topics in Quantum Electronics 28.2: Optical Detectors (2021): 1-10).

Invertierte nSPAD-Strukturen wurden ebenfalls bereits mit BCD-Technologien realisiert. Aus Han, Dong, et al. "A scalable single-photon avalanche diode with improved photon detection efficiency and dark count noise." Optik 212 (2020): 164692 ist beispielsweise eine skalierbare Einzelphotonen-Lawinendiode (SPAD) mit einem virtuellen epitaktischen Schutzring bekannt, die auf einer BCD-Technologie basiert. Ein tiefer Übergang zwischen einer p-Wanne (engl. "pwell, PW") und einer Mittelspannungs-p-Wanne (engl. "medium-voltage-n-well, MVNW") dient dabei als Lawinengebiet zur Verbesserung der PDE und der spektralen Empfindlichkeit. Darüber hinaus wird eine tiefliegende n⁺-Schicht (engl. "n-type buried layer, NBL") verwendet, um eine Substratisolation zur Verringerung des elektrischen Übersprechens und zur Erleichterung der Pixelintegration zu ermöglichen. Insbesondere wird eine niedrig dotierte p-Typ-Epitaxieschicht als virtueller Schutzring verwendet, der eine durch Grenzflächenfallen verursachte Dunkelzählrate (engl. "dark count rate, DCR") wirksam unterdrücken kann. Auch aus Veerappan, Chockalingam, and Edoardo Charbon. "A low dark count pin diode based SPAD in CMOS technology." IEEE transactions on electron devices 63.1 (2015): 65-71 sowie Sanzaro, Mirko, et al. "Single-photon avalanche diodes in a 0.16 µm BCD technology with sharp timing response and red-enhanced sensitivity." IEEE Journal of Selected Topics in Quantum Electronics 24.2 (2017): 1-9 sind invertierte nSPADs in BCD-Technologien bekannt.

Die im Stand der Technik in BCD-Technologie realisierten invertierten nSPADs basieren überwiegend auf p-n-Strukturen, welche als n-Schicht eine von der Oberfläche eines BCD-Substrats eingebrachte tiefe n-Wanne (engl. "deep n-well, DNW") verwenden. Die Photonenabsorption und die Ladungsträgererzeugung findet bei solchen SPADs überwiegend im breiten eigenleitenden (intrinsischen) Bereich zwischen einer ersten p-Schicht und einer zweiten p-Schicht statt. Durch eine breite intrinsische Schicht können das effektiv zur Absorption zur Verfügung stehende Gebiet und somit auch die Absorptionswahrscheinlichkeit und die PDE erhöht werden. Zudem wird dadurch auch die Sperrschichtkapazität verringert, wodurch die Detektortotzeit reduziert werden kann. Die Absorptionstiefe der Photonen ist dabei trotz des invertierten nSPAD-Aufbaus noch immer zu gering, um insbesondere im nahinfraroten Spektralbereich (NIR) einen hohen Photonen-Einfangwirkungsgrad erreichen zu können.

Um die Absorptionstiefe noch weiter erhöhen zu können, muss der p-n-Übergang unterhalb des intrinsischen Bereichs tiefer im BCD-Substrat bereitgestellt werden. Dies ist bei bereits vollständig entwickelten Fertigungsabläufen für die integrierten Schaltungen nicht trivial und erfordert üblicherweise die Hinzunahme zusätzlicher Prozessschritte. Insbesondere können hierzu zusätzliche Masken-, Lithographie- und Epitaxieschritte erforderlich sein. Dabei ist zu beachten, dass diese zusätzlichen Schritte auch mit den Prozessschritten zur Erzeugung der übrigen Komponenten einer integrierten Schaltung, z. B. einem integrierten Verstärker oder einem angeschlossenen Photonenzählwerk, kompatibel sein müssen. Hohe Wirkungsgrade sind bei hoher Eindringtiefe und bei einem Elektronen-basierten Durchbruch zu erreichen. Die tiefste zu Verfügung stehende n-Schicht innerhalb eines üblichen BCD-Prozesses mit Epitaxie ist die N BL-Schicht. Jedoch ist dann keine typische, von der Oberfläche eingebrachte p-Wanne geeignet, einen passenden Durchbruchmechanismus (mit einem geeigneten Wert für die Durchbruchspannung V_{BD} < 40 V) bereitzustellen.

Es ist daher eine Aufgabe der vorliegenden Erfindung, ein Verfahren zur Erzeugung tiefliegender p-n-Übergänge in einem BCD-Prozess, ein BCD-Substrat mit einem tiefliegenden p-n-Übergang und eine darauf basierende Einzelphotonen-Lawinendiode bereitzustellen. Das Verfahren zur Erzeugung tiefliegender p-n-Übergänge in einem BCD-Prozess soll dabei möglichst ohne zusätzlichen Prozessaufwand auskommen und kompatibel zu bestehenden BCD-Prozessen sein. Ein entsprechendes BCD-Substrat mit einem tiefliegenden p-n-Übergang kann dann die Basis zur Ausbildung einer hocheffizienten Einzelphotonen-Lawinendiode mit breitem Absorptionsgebiet bilden. Die SPAD-Detektoren sollen mit einfachen, schaltungstechnischen Lösungen ansteuerbar und gleichzeitig hocheffektiv für den NIR-Spektralbereich sein.

### Beschreibung der Erfindung

Die erfindungsgemäße Aufgabe wird gelöst durch die Gegenstände der unabhängigen Patentansprüche. Bevorzugte Weiterbildungen sind Gegenstand der Unteransprüche.

Ein erster Aspekt der vorliegenden Offenbarung betrifft ein Verfahren zur Erzeugung tiefliegender p-n-Übergänge in einem BCD-Prozess, umfassend ein Bereitstellen eines Trägersubstrats; ein Einbringen eines ersten Dotierstoffs zur Ausbildung eines ersten Gebiets vom ersten Leitungstyp in eine Oberfläche des Trägersubstrats; ein Aufwachsen einer epitaktischen Schicht auf die Oberfläche des Trägersubstrats, wobei sich das erste Gebiet durch Diffusion des ersten Dotierstoffs in der epitaktischen Schicht und in dem Trägersubstrat ausbreitet; und ein Einbringen eines zweiten Dotierstoffs zur Ausbildung eines zweiten Gebiets vom zweiten Leitungstyp in einen Bereich des ersten Gebiets, wobei sich das erste Gebiet und das zweite Gebiet zumindest teilweise überlagern, und das Einbringen des zweiten Dotierstoffs derart gewählt ist, dass der erste und zweite Dotierstoff durch das Einbringen einen in der epitaktischen Schicht liegenden p-n-Übergang ausbilden.

Vorzugsweise erfolgt ein Einbringen eines zweiten Dotierstoffs zur Ausbildung eines zweiten Gebiets vom zweiten Leitungstyp in einen Bereich des ersten Gebiets mittels Hochenergie-Implantation des zweiten Dotierstoffs.

In einer bevorzugten Ausführungsform des Verfahrens erfolgt das Einbringen des zweiten Dotierstoffs vor dem Aufwachsen der epitaktischen Schicht in die Oberfläche des Trägersubstrats (d. h. analog zum Einbringen des ersten Dotierstoffs). Dabei ist besonders bevorzugt, dass sich (nach dem Aufwachsen der epitaktischen Schicht) das erste Gebiet und das zweite Gebiet durch Diffusion des ersten Dotierstoffs und des zweiten Dotierstoffs in der epitaktischen Schicht und in dem Trägersubstrat ausbreiten, wobei das Diffusionsverhalten des ersten und des zweiten Dotierstoffs derart gewählt sind, dass der erste und zweite Dotierstoff durch Diffusion den in der epitaktischen Schicht liegenden p-n-Übergang ausbilden.

Ein zweiter Aspekt der vorliegenden Offenbarung betrifft ein Verfahren zur Erzeugung tiefliegender p-n-Übergänge in einem BCD-Prozess, umfassend ein Bereitstellen eines Trägersubstrats; ein Einbringen eines ersten Dotierstoffs zur Ausbildung eines ersten Gebiets vom ersten Leitungstyp in eine Oberfläche des Trägersubstrats; ein Einbringen eines zweiten Dotierstoffs zur Ausbildung eines zweiten Gebiets vom zweiten Leitungstyp in die Oberfläche des Trägersubstrats, wobei sich das erste Gebiet und das zweite Gebiet zumindest teilweise überlagern; und ein Aufwachsen einer epitaktischen Schicht auf die Oberfläche des Trägersubstrats, wobei sich das erste Gebiet und das zweite Gebiet durch Diffusion des ersten Dotierstoffs und des zweiten Dotierstoffs in der epitaktischen Schicht und in dem Trägersubstrat ausbreiten, wobei das Diffusionsverhalten des ersten und des zweiten Dotierstoffs derart gewählt sind, dass der erste und zweite Dotierstoff durch Diffusion einen in der epitaktischen Schicht liegenden p-n-Übergang ausbilden.

Die folgenden Ausführungen betreffen beide zuvor genannten Aspekte gleichermaßen und sind daher zusammen behandelt.

Vorzugsweise bilden der erste und zweite Dotierstoff durch das Einbringen (insbesondere durch das Einbringen des zweiten Dotierstoffs, wobei jedoch beispielsweise auch die räumliche Verteilung beim Einbringen des ersten Dotierstoffs einen Einfluss hat) und/oder durch Diffusion (hierbei hat neben den ausgewählten Diffusionsparametern insbesondere die räumliche Verteilung beim Einbringen des ersten und zweiten Dotierstoff einen erheblichen Einfluss) jeweils einen in der epitaktischen Schicht und einen in dem Trägersubstrat liegenden p-n-Übergang ausbilden. Eine Diffusionsbewegung unter Ausbildung von mindestens einem p-n-Übergang kann nach einem Einbringen von Dotierstoffen auch bei einem erfindungsgemäßen Verfahren gemäß dem beschriebenen ersten Aspekt erfolgen.

Als p-n-Übergang wird dabei insbesondere ein Bereich oder Gebiet innerhalb des Substrats verstanden, in dem ein p-dotiertes Halbleitermaterial flächig an ein n-dotiertes Halbleitermaterial angrenzt und sich im Übergangsbereich zwischen den beiden Materialien eine für p-n-Übergänge typische Verarmungszone ausbilden kann. Ein p-n-Übergang wird somit lokal über die jeweiligen Strukturen an der entsprechenden Stelle definiert. Insofern kann ein entsprechender p-n-Übergang auch als p-n-Übergangsbereich (oder p-n-Übergangsgebiet) bezeichnet werden. Der Begriff "p-n-Übergang" soll jedoch, soweit in der Beschreibung im Einzelfall nichts anderes angegeben ist, nicht als allgemeiner Bezeichner für eine von einem solchen p-n-Übergangsbereich ausgebildete elektronische Struktur an sich verstanden werden. Zwei unmittelbar benachbarte p-n-Übergangsbereiche in unterschiedlichen Gebieten (z. B. epitaktische Schicht und Trägersubstrat) bilden daher getrennte p-n-Übergänge aus, auch wenn diese durchaus eine gemeinsame zusammenhängende Struktur ausbilden können (d. h. eine gemeinsame p-n-Übergangsstruktur umfassend zwei miteinander verbundene p-n-Übergangsbereiche).

Ein in der epitaktischen Schicht liegender p-n-Übergang ist daher gekennzeichnet durch einen in der epitaktischen Schicht liegenden Grenzbereich zwischen einem p-dotierten Halbleitermaterial und einem n-dotierten Halbleitermaterial. Entsprechend ist ein in dem Trägersubstrat liegender p-n-Übergang gekennzeichnet durch einen in dem Trägersubstrat liegenden Grenzbereich zwischen einem p-dotierten und einem n-dotierten Halbleitermaterial.

Bei dem Trägersubstrat kann es sich bevorzugt um ein p-Substrat handeln. Es können jedoch auch n-Substrate oder intrinsische Substrate verwendet werden. Bei dem Substratmaterial kann es sich insbesondere um Silizium handeln. Ein typischer Dotierstoff zur Ausbildung eines p-Gebiets ist Bor. Zur Ausbildung eines n-Gebiets kann Phosphor verwendet werden. Dabei diffundiert beispielsweise in Silizium Bor als Dotierstoff deutlich schneller und damit auch weiter aus als Phosphor. Zudem kann festgestellt werden, dass dabei die erzeugten n-Gebiete bei den üblicherweise gewählten Dosen für beide Dotierstoffe weitgehend dominant sind, d. h. ein bereits mit Phosphor dotiertes n-Gebiet kann auch nach einem zusätzlichen Einbringen von Bor seinen vorhandenen Leitungstyp beibehalten. Für die Bereitstellung der tiefliegenden p-n-Übergänge kann somit auf zusätzliche Masken-, Lithographie- und Epitaxieschritte im üblichen BCD-Prozess verzichtet werden.

Vorzugsweise weisen der erste und der zweite Dotierstoff ein unterschiedliches Diffusionsverhalten im Trägersubstrat und/oder in der epitaktischen Schicht auf. Bevorzugt weist der zweite Dotierstoff eine höhere Diffusivität (auch als Diffusionsbeweglichkeit bezeichnet) im Trägersubstrat und/oder in der epitaktischen Schicht auf als der erste Dotierstoff. Dabei kann insbesondere auch zusätzlich von der Oberfläche her das sogenannte Diffusion Engineering zur Anwendung kommen, bei dem die einzelnen Dotierstoffe derart von der Oberfläche eingebracht werden, dass sich zur Oberfläche hin ein im Wesentlichen ansteigendes Dotierstoffprofil einstellt. Hierbei ergibt sich jedoch im Allgemeinen kein streng monotones Profil, sondern die Übergänge weisen zumeist einen gewissen Grad an Stufig- bzw. Welligkeit auf. Das Diffusionsverhalten von verschiedenen Dotierstoffen in epitaktisch gewachsenen Schichten sowie in typischerweise als Trägersubstrat verwendeten Materialien ist dem Fachmann hinreichend bekannt bzw. kann von diesem auf bekannte Weise zumindest überschlägig berechnet werden. Eine Festlegung des ersten und des zweiten Dotierstoffs sowie der zugehörigen Parameter zum Einbringen in eine Oberfläche des Trägersubstrats zur erfindungsgemäßen Ausbildung jeweils eines in der epitaktischen Schicht und eines in dem Trägersubstrat liegenden p-n-Übergangs durch Diffusion kann vom Fachmann somit ohne Weiteres vorgenommen werden.

Vorzugsweise erfolgt nach dem Einbringen des ersten Dotierstoffs und/oder des zweiten Dotierstoffs eine Erwärmung des Trägersubstrats zur Verstärkung der Diffusion; dies kann auch während der Epitaxieschritte erfolgen, da diese in der Regel sehr hohe Prozess-Temperaturen benötigen. Nach dem Aufwachsen der epitaktischen Schicht(en) kann ebenso eine Erwärmung des Trägersubstrats zur Verstärkung der Dotierstoffdiffusion erfolgen.

Vorzugsweise erfolgt das Einbringen des ersten Dotierstoffs und/oder des zweiten Dotierstoffs maskenlos oder über ein Maskenverfahren. Zum maskenlosen Einbringen kann beispielsweise ein direktes lonenstrahlschreibverfahren verwendet werden. Bei einem Maskenverfahren erfolgt das Einbringen mit Hilfe einer zuvor bereitgestellten Maske, wobei das Einbringen beispielsweise über ein chemisches oder physikalisches Abscheideverfahren oder ebenfalls mittels eines lonenstrahlschreibverfahrens erfolgt.

Vorzugsweise überlagert unmittelbar nach dem Einbringen des zweiten Dotierstoffs in einer Aufsicht auf die Oberfläche des Trägersubstrats das erste Gebiet oder das zweite Gebiet vollständig das jeweils anderen Gebiet, oder das erste Gebiet und das zweite Gebiet überlagern sich nur in den Randbereichen. Der Begriff "Randbereich" bedeutet dabei, dass daneben anschließend zumindest noch ein überlagerungsfreier Hauptbereich existiert. Eine Überlagerung nur in den Randbereichen kann auch das Umschließen eines Gebietes durch das jeweils andere umfassen, wobei das umschlossene Gebiet in einem zentralen Bereich nicht vom jeweils anderen Gebiet überlagert wird.

Vorzugsweise wird unmittelbar nach dem Einbringen des zweiten Dotierstoffs in einer Aufsicht auf die Oberfläche des Trägersubstrats das erste Gebiet an einem linken und rechten Randbereich von den Randbereichen zweier zweiter Gebiete überlagert, oder das zweite Gebiet wird an einem linken und rechten Randbereich von den Randbereichen zweier erster Gebiete überlagert.

Vorzugsweise handelt es sich bei dem ersten Gebiet um eine tiefliegende n-Schicht (NBL-Schicht) und bei dem zweiten Gebiet um eine tiefliegende p-Schicht (PBL-Schicht).

Ein erfindungsgemäßes Verfahren ermöglicht die Erzeugung tiefliegender p-n-Übergänge in einem üblichen BCD-Prozess. Dabei kann auf einen zusätzlichen Prozessaufwand weitgehend verzichtet werden. Insbesondere ist ein erfindungsgemäßes Verfahren somit auch kompatibel zu den weiteren Prozessschritten einer auf der Bereitstellung tiefliegender n- und p-dotierter Schichten basierenden konventionellen BCD-Technologie. Die Möglichkeit zum direkten maskenlosen Erzeugen von tiefliegenden p-n-Übergängen ist gegeben. Ein besonderer Vorteil eines erfindungsgemäßen Verfahrens ist dabei, dass je nach Ausgestaltung des Verfahrens mehrere voneinander unabhängige p-n-Übergange in einem Verfahrensschritt an einer im Wesentlichen gleichen Stelle des Trägersubstrats realisiert werden können. Insbesondere kann bei einigen Ausführungsformen eines erfindungsgemäßen Verfahrens neben einem oberen, im Wesentlichen in der epitaktischen Schicht liegenden, ersten p-n-Übergang mithin auch ein weitgehend identischer unterer, im Wesentlichen im Trägersubstrat liegender, zweiter p-n-Übergang bereitgestellt werden. Die Ausbildung bezüglich Form und Anzahl der bereitgestellten p-n-Übergänge lässt sich dabei über das verwendete Dotierstoffprofil und die gewünschte Lage der tiefliegenden n- und p-dotierten Schichten einstellen.

Ein dritter Aspekt der vorliegenden Offenbarung betrifft ein BCD-Substrat mit einem tiefliegenden p-n-Übergang, umfassend ein Trägersubstrat; und eine auf dem Trägersubstrat aufgewachsene epitaktische Schicht, wobei zwischen dem Trägersubstrat und der epitaktischen Schicht durch ein erfindungsgemäßes Verfahren gemäß dem beschriebenen ersten Aspekt oder durch eine Diffusion von in eine Oberfläche des Trägersubstrats unterhalb der epitaktischen Schicht eingebrachten Dotierstoffen ein in der epitaktischen Schicht liegender p-n-Übergang erzeugt wurde. Insbesondere kann ein erfindungsgemäßes BCD-Substrat mittels eines entsprechenden erfindungsgemäßen Verfahrens bereitgestellt werden. Die zum erfindungsgemäßen Verfahren sowie zu dessen als bevorzugt angegebenen Ausführungsformen gemachten Beschreibungen und Erläuterungen gelten für ein erfindungsgemäßes BCD-Substrat entsprechend. Dies betrifft insbesondere die Ausbildung und Anordnung der unterschiedlichen Gebiete.

Vorzugsweise wurde jeweils ein in der epitaktischen Schicht und ein in dem Trägersubstrat liegender p-n-Übergang erzeugt. In diesem Fall weist das erfindungsgemäße BCD-Substrat somit zwei gemeinsam erzeugte p-n-Übergänge auf.

Ein weiterer Aspekt der vorliegenden Offenbarung betrifft eine Einzelphotonen-Lawinendiode (SPAD) umfassend ein erfindungsgemäßes BCD-Substrat, wobei ein Bereich um einen p-n-Übergang ein Lawinengebiet ausbildet, und ein Absorptionsgebiet zur Umwandlung von Photonen in Elektronen-Lochpaare, wobei sich das Absorptionsgebiet unmittelbar an die den p-n-Übergang ausbildenden Gebiete (d. h. die sich erfindungsgemäß diffusionsgetrieben überlagernden NBL- und PBL-Schichten) anschließt.

Vorzugsweise ist der p-n-Übergang zumindest teilweise zwischen einer tiefliegenden n-Schicht (NBL-Schicht) als Kathode und einer sich unmittelbar an die tiefliegende n-Schicht anschließenden tiefliegenden p-Schicht (PBL-Schicht) ausgebildet. Bevorzugt schließt sich das Absorptionsgebiet unmittelbar an die tiefliegende p-Schicht an und ist als p-Gebiet ausgebildet. Bevorzugt ist weiterhin, dass eine als p+-Gebiet ausgebildete Anode sich unmittelbar an das Absorptionsgebiet anschließt. Typischerweise wird zur Vermeidung von elektrischen Feldüberhöhungen an den Ecken das Detektorgebiet radial-symmetrisch oder zumindest mit stumpfen Winkeln oder besser mit Kantenabrundungen ausgebildet.

Vorzugsweise umfasst das Absorptionsgebiet eine sich unmittelbar an die tiefliegende p-Schicht anschließende Hochvolt-p-Wanne und optional ein sich unmittelbar daran anschließende p-Wanne. Das Absorptionsgebiet fungiert dabei effektiv als intrinsische Zone einer entsprechenden p-i-n-Photodiode.

Vorzugsweise ist das Absorptionsgebiet zwischen der tiefliegenden p-Schicht und der Anode als leicht n-dotiertes, epitaktisches Gebiet mit einer als Kanal ausgebildeten Hochvolt-p-Wanne als nicht-linearer Quenching-Widerstand ausgebildet.

Vorzugsweise ist entlang der tiefliegenden n-Schicht eine Vielzahl von unmittelbar oberhalb der tiefliegenden n-Schicht angeordneten separaten tiefliegenden p-Schichten ausgebildet. Eine solche Konfiguration ermöglicht die parallele Anordnung mehrerer identischer oder zumindest bauähnlicher Dioden. Dadurch kann eine erfindungsgemäße Einzelphotonen-Lawinendiode mit einer Vielzahl von nebeneinander angeordneten, weitgehend voneinander unabhängigen aktiven Gebieten ausgebildet werden, was im Grunde einer Parallelschaltung einer Vielzahl von im Wesentlichen identischen Einzelphotonen-Lawinendioden entspricht. Abhängig von der Anzahl der integrierten Dioden kann eine solche Gesamt-Konfiguration weitestgehend frei von Totzeit sein, da auch direkt nach einer ersten Detektion ein oder mehrere weitere Photonenereignisse an anderen, aktiv verbleibenden Dioden detektiert werden können.

Eine typische Dicke für die aufgewachsene epitaktischen Schicht (und somit für die Tiefe des p-n-Übergangs im BCD-Substrat) liegt bei etwa 5-10 µm. Dadurch kann insbesondere eine hohe Durchbruchspannung erreicht werden. Die in großer Tiefe hinterlegte NBL-Schicht und die von der Oberfläche einbringbaren p-Wannen können dann eine große intrinsische Zone bereitstellen, welche auch eine hohe Durchbruchspannung mit sich bringt und als breites Absorptionsgebiet für eine entsprechende SPAD dienen kann.

Unter weitgehender Verwendung konventioneller BCD-Techniken wurde somit eine neuartige Struktur geschaffen, welche sich von anderen, bereits im Stand der Technik bekannten SPAD-Strukturen systematisch unterscheidet. Bei einer erfindungsgemäßen Einzelphotonen-Lawinendiode kann es sich insbesondere um eine invertierte nSPAD handeln, welche eine höhere PDE insbesondere für eine Detektion im infraroten Spektralbereich ermöglichen. Der erfindungsgemäße Detektor bietet alle Vorteile einer nSPAD und verbessert deren Eigenschaften durch eine breitere Absorptionsschicht, wobei der Einzelphotonendetektor jedoch im Prinzip wie eine herkömmliche oberflächenbezogene pSPAD verwendet werden kann. Die Begriffe nSPAD und pSPAD dienen dabei zur Kennzeichnung dafür, welche Art der Ladungsträger überwiegend für die Ausbildung der Stoßionisation, d. h. für die Lawinenausbildung in der SPAD, verantwortlich ist. Bei einer nSPAD sind dies insbesondere die negativ geladenen Elektronen, während bei einer pSPAD vor allem die positiv geladenen Löcher für die Lawinenausbildung verantwortlich sind.

Aufgrund der verwendeten BCD-Technologieplattform, welche eine optimale Integration verschiedenster Anwendungen aus unterschiedlichen Bereichen ermöglicht, können die im BCD-Substrat vergrabenen Bauelemente, insbesondere eine erfindungsgemäße Einzelphotonen-Lawinendiode, auch direkt oberhalb des vergrabenen Bauelements oder unmittelbar seitlich angrenzend mit weiteren Bauelementen und Komponenten kombiniert werden. Beispielsweise können neben analogen und digitalen Verstärkerelementen auch digitale Speicherelemente und Signalprozessoren zur statistischen Auswertung und zum Aufbau von Einzelphotonenzählwerken bzw. Einzelphotonenzählern realisiert werden.

Durch eine über ein erfindungsgemäßes Verfahren ermöglichte Verlagerung des für die Funktion der Einzelphotonen-Lawinendiode relevanten p-n-Übergangs in eine größere Tiefe kann die Oberfläche des verwendeten BCD-Substrats für verbesserte optische Eigenschaften bewusst strukturiert werden (z. B. Wechsel von Aktivgebiet/STI (engl. "shallow trench isolation") und/oder Poly), ohne dass dabei die Eigenschaften des vergrabenen Bauelements wesentlich verändert oder beeinflusst werden. Dies ermöglicht vor allem eine hohe Flexibilität beim Design von entsprechenden integrierten Schaltungen und bei der Strukturierung der Oberfläche. Da die relevante p-n-Struktur nicht oberflächenbezogen ist, muss die bekannte BEOL-Interferenz-Bedingung nicht strikt berücksichtigt werden, wodurch die Ausprägung der spektralen Resonanzmaxima und -minima (engl. "spectral response fringes") durch einfache ACTI/STI-Strukturierung bzw. Modulation reduziert werden können.

Die erfindungsgemäßen Einzelphotonendetektoren, insbesondere wenn diese mit einem vollständig integrierten nicht-linearen Quenching-Widerstand ausgebildet sind, können unterschiedlich, z. B. als Einzelpixel innerhalb eines Arrays oder auch als sogenannte Silizium-Photomultiplier (SiPM), verwendet werden. Durch eine erfindungsgemäße Ausbildung sind nahezu beliebig große Detektorflächen (wenige µm² bis mm²) ohne sichtbare Pixelgrenzen bei Ausnutzung von nahezu 100% der effektiven Fläche (d. h. bei hohem Füllfaktor) möglich.

Ein weiterer Vorteil der erfindungsgemäßen BCD-Struktur einer Einzelphotonen-Lawinendiode ist die Möglichkeit zur variablen Einstellung der Durchbruchspannung der Dioden durch einfaches Anpassen des zugrundeliegenden Strukturdesigns. Beispielsweise kann die Durchbruchspannung über die Größe des Bereichs der tiefliegenden p-Schicht signifikant beeinflusst und somit entsprechend eingestellt werden. Die gewählte Durchbruchspannung kann dabei einheitlich sein oder auch bewusst unterschiedlich, wenn es die Applikation erfordert.

Die tiefe Lage des oder der erfindungsgemäß bereitgestellten p-n-Übergänge und damit der darüber realisierten isolierten und einzeln adressierbaren Einzelphotonen-Lawinendioden ermöglicht zudem auch ein Adressieren bzw. Auslesen der Strukturen in einer sogenannten Lowside-Konfiguration. Diese Lowside-Auslesung erlaubt eine größere Flexibilität beim Schaltungsdesign bzw. beim Aufbau entsprechender integrierter Schaltungen.

Mit einem erfindungsgemäßen Verfahren lassen sich zwei nahezu identisch aufgebaute p-n-Übergänge im BCD-Substrat erzeugen. Dies stellt mittels entsprechender Skalierung eine ideale Plattform für künftige SPAD-Entwicklungen bereit. Während beispielsweise ein in der epitaktischen Schicht ausgebildeter oberer p-n-Übergang eine erste SPAD bereitstellen kann, ermöglicht ein zweiter p-n-Übergang im Trägersubstrat beispielsweise die Ausbildung einer weitgehend identischen zweiten SPAD.

Dies ermöglicht zum einen eine besonders kompakte 3D-Integration von mehreren Detektorelementen, zum anderen lassen sich dadurch wesentliche Verbesserungen bei den Detektionseigenschaften erzielen sowie gänzlich neue Anwendungsfelder erschließen. Beide p-n-Übergänge sind dabei prinzipiell sowohl für eine Vorderseiten- als auch für eine Rückseitenbeleuchtung geeignet. Bei der zweiten SPAD handelt es sich im Prinzip um ein eigenständiges, von der ersten SPAD weitestgehend unabhängiges Bauelement, so dass über eine entsprechende Kontaktierung auch eine separate Auslesung möglich ist. Dadurch wird grundsätzlich auch die Bereitstellung eines sogenannten Back-Side Imagers (BSI) am unteren p-n-Übergang alleine oder in Kombination mit einem sogenannten Front-Side Imager (FSI) am oberen p-n-Übergang ermöglicht.

Ein weiterer Vorteil eines erfindungsgemäßen tiefliegenden p-n-Übergangs ist dessen einfache Skalierbarkeit. Eine Trennung benachbarter Diodenstrukturen kann durch eine einfache Strukturierung von entsprechenden Isolationsgebebieten an der Oberfläche des BCD-Substrats erfolgen.

Ein weiterer Aspekt der vorliegenden Offenbarung betrifft eine integrierte Schaltung, umfassend mindestens eine erfindungsgemäße Einzelphotonen-Lawinendiode.

Weitere Aspekte der vorliegenden Erfindung sind in den abhängigen Ansprüchen oder in der folgenden Beschreibung der Zeichnungen offenbart.

### Kurze Beschreibung der Figuren

Die Erfindung wird nachfolgend in Ausführungsbeispielen anhand der zugehörigen Zeichnungen erläutert. Es zeigen:
- Figur 1: eine schematische Darstellung einer ersten Ausführungsform eines Verfahrens zur Erzeugung tiefliegender n- und p-dotierter Schichten in einem BCD-Prozess gemäß Stand der Technik;
- Figur 2: eine schematische Darstellung einer zweiten Ausführungsform eines Verfahrens zur Bereitstellung tiefliegender n- und p-dotierter Schichten in einem
- Figur 3: BCD-Prozess gemäß Stand der Technik; eine schematische Darstellung einer ersten Ausführungsform ("Saturn") eines erfindungsgemäßen Verfahrens zur Bereitstellung tiefliegender p-n-Übergänge in einem BCD-Prozess und eine TCAD-Darstellung der resultierenden Dotierstoffverteilung;
- Figur 4: eine schematische Darstellung einer zweiten Ausführungsform ("Donut") eines erfindungsgemäßen Verfahrens zur Bereitstellung tiefliegender p-n-Übergänge in einem BCD-Prozess und eine TCAD-Darstellung der resultierenden Dotierstoffverteilung;
- Figur 5: eine schematische Darstellung einer dritten Ausführungsform ("Pacman") eines erfindungsgemäßen Verfahrens zur Bereitstellung tiefliegender p-n-Übergänge in einem BCD-Prozess und eine TCAD-Darstellung der resultierenden Dotierstoffverteilung;
- Figur 6: Strom-Spannungs-Kennlinien eines in Sperrrichtung Uᵣₑᵥ betriebenen tiefliegenden p-n-Übergangs erzeugt mit einem erfindungsgemäßen Verfahren entsprechend der ersten Ausführungsform nach FIG. 3 inklusive eines passiven Quenching-Widerstands und ohne Beleuchtung;
- Figur 7: eine schematische Darstellung einer in BCD-Technologie hergestellten Einzelphotonen-Lawinendiode gemäß Stand der Technik;
- Figur 8: eine schematische Darstellung einer ersten Ausführungsform einer erfindungsgemäßen Einzelphotonen-Lawinendiode;
- Figur 9: eine schematische Darstellung einer zweiten Ausführungsform einer erfindungsgemäßen Einzelphotonen-Lawinendiode; und
- Figur 10: eine schematische Darstellung einer dritten Ausführungsform einer erfindungsgemäßen Einzelphotonen-Lawinendiode.

### Detaillierte Beschreibung der Figuren

Es werden nun detaillierte Ausführungsformen beschrieben, die beispielhaft in den beigefügten Zeichnungen dargestellt sind. Die Wirkungen und Merkmale dieser Ausführungsformen werden unter Bezugnahme auf die beigefügten Zeichnungen beschrieben. In den Zeichnungen bezeichnen gleiche Bezugsziffern gleiche Elemente und auf redundante Beschreibungen wird verzichtet. Die vorliegende Offenbarung kann in verschiedenen Formen verwirklicht werden und ist nicht so zu verstehen, dass sie nur auf die hier dargestellten Ausführungsformen beschränkt ist. Vielmehr sind diese Ausführungsformen Beispiele, damit diese Offenbarung gründlich und vollständig ist und dem Fachmann die Aspekte und Merkmale der vorliegenden Offenbarung vollständig vermittelt.

Verfahren, Elemente und Techniken, die für den Fachmann zum vollständigen Verständnis der Aspekte und Merkmale der vorliegenden Offenbarung nicht notwendig sind, werden daher gegebenenfalls nicht beschrieben. In den Zeichnungen können die relativen Größen von Elementen, Schichten und Bereichen zur Verdeutlichung übertrieben dargestellt sein.

Wie hierin verwendet, schließt der Begriff "und/oder" alle Kombinationen von einem oder mehreren der aufgeführten Elemente ein. Ferner bezieht sich die Verwendung von "kann" bei der Beschreibung von Ausführungsformen der vorliegenden Offenbarung auf "eine oder mehrere Ausführungsformen der vorliegenden Offenbarung". In der folgenden Beschreibung von Ausführungsformen können die Begriffe in der Einzahl auch die Mehrzahl umfassen, sofern aus dem Kontext nicht eindeutig etwas Anderes hervorgeht.

Obwohl die Begriffe "erste" und "zweite" zur Beschreibung verschiedener Elemente verwendet werden, sollten diese Elemente nicht durch diese Begriffe eingeschränkt werden. Diese Begriffe werden nur verwendet, um ein Element von einem anderen Element zu unterscheiden. So kann beispielsweise ein erstes Element als zweites Element bezeichnet werden, und ebenso kann ein zweites Element als erstes Element bezeichnet werden, ohne dass dies vom Anwendungsbereich der vorliegenden Offenbarung abweicht. Ausdrücke wie "mindestens eines von", wenn sie einer Liste von Elementen vorangestellt werden, modifizieren die gesamte Liste und nicht nur die einzelnen Elemente der Liste.

Begriffe wie "im Wesentlichen", "ungefähr" und ähnliche werden als Annäherungsbegriffe und nicht als Gradangaben verwendet und sollen die inhärenten Abweichungen bei gemessenen oder berechneten Werten berücksichtigen, die von Fachleuten erkannt werden. Wenn der Begriff "im Wesentlichen" in Verbindung mit einem Merkmal verwendet wird, das durch einen numerischen Wert ausgedrückt werden kann, bezeichnet der Begriff "im Wesentlichen" einen Bereich von zumindest +/- 5 % des Wertes, der auf den Wert zentriert ist.

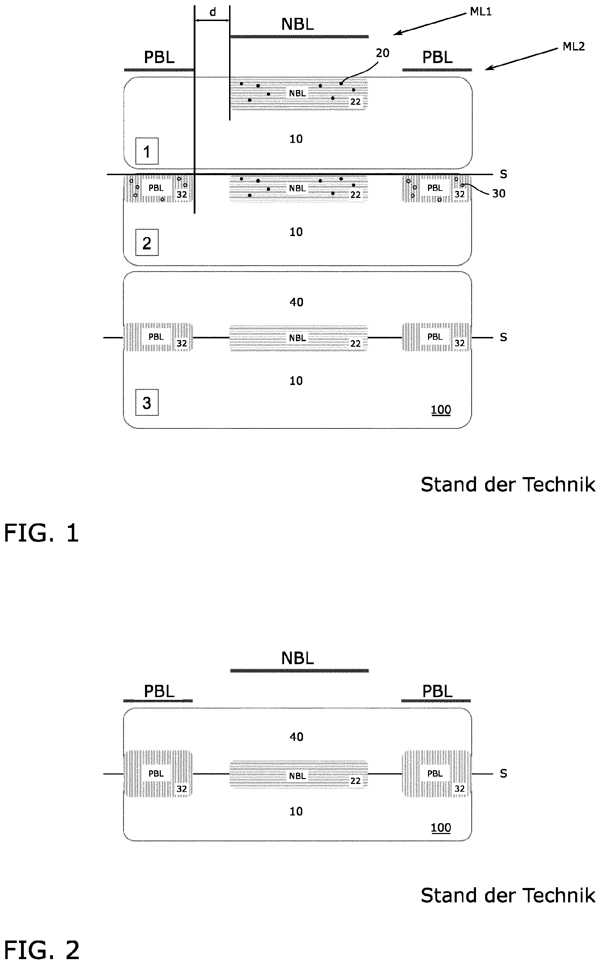

Figur 1 zeigt eine schematische Darstellung einer ersten Ausführungsform eines Verfahrens zur Erzeugung tiefliegender n- und p-dotierter Schichten in einem BCD-Prozess gemäß Stand der Technik. Das Verfahren basiert im Wesentlichen auf den drei hierzu gezeigten Schritten, wobei die im oberen Bereich der Figur gezeigten Balken die durch eine eventuelle erste Maskenschicht ML1 und eine eventuelle zweite Maskenschicht ML2 zu strukturierenden Gebiete jeweils für den ersten und zweiten Schritt in der Darstellung veranschaulichen sollen. Diese sind entsprechend den in der Figur gezeigten tiefliegenden Schichten mit NBL für eine tiefliegende n-Schicht (engl. "n-type buried layer") und mit PBL für eine tiefliegende p-Schicht (engl. "p-type buried layer") bezeichnet.

Die Figur zeigt eine für BCD-Technologien häufig verwendete Basisanordnung bestehend aus einer seitlich zwischen zwei tiefliegenden p-Schichten eingeschlossenen breiten tiefliegenden n-Schicht. Es handelt sich jedoch lediglich um ein rein illustratives Beispiel. Die Größe und Anordnung der einzelnen tiefliegenden Schichten ist durch das verwendete Verfahren nicht näher bestimmt und kann daher beliebig variiert werden. Ebenfalls variiert werden kann die Reihenfolge der dargestellten ersten und zweiten Schritte. Im gezeigten Beispiel der FIG. 1 wird zunächst die NBL-Schicht bereitgestellt und anschließend werden die beiden PBL-Schichten erzeugt. Die im Folgenden hinter den Bezugszeichen in Klammern angegeben Konkretisierungen beziehen sich daher lediglich auf die in den Figuren beispielhaft gezeigten Sachverhalte, sollen das Verfahren diesbezüglich jedoch in keiner Weise dahingehend einschränken. Weiterhin zeigen die Darstellungen zu den Verfahren lediglich die Dotierungsprofile und die sich dabei einstellenden Diffusionsprofile in stark vereinfachter Form. Insbesondere an scharfen Kanten der Dotierungsprofile kann es aufgrund verschieden Effekte bei der praktischen Umsetzung zu Abweichungen in der Schichtform kommen.

Das gezeigte Verfahren zur Erzeugung tiefliegender n- und p-dotierter Schichten NBL und PBL in einem BCD-Prozess umfasst ein Bereitstellen eines Trägersubstrats 10 (dieser Schritt ist nicht explizit gezeigt); ein Einbringen eines ersten Dotierstoffs 20 zur Ausbildung eines ersten Gebiets 22 (in gezeigten Beispiel ein NBL-Schicht) vom ersten Leitungstyp (negativ) in eine Oberfläche S des Trägersubstrats 10; ein Einbringen eines zweiten Dotierstoffs 30 zur Ausbildung mindestens eines zweiten Gebiets 32 (PBL) vom zweiten Leitungstyp (positiv) in die Oberfläche S des Trägersubstrats 10, wobei das erste Gebiet 22 (NBL) und das zweite Gebiet 32 (PBL) in einem Abstand d beabstandet voneinander ausgebildet werden; und ein Aufwachsen einer epitaktischen Schicht 40 auf die Oberfläche S des Trägersubstrats 10, wobei sich das erste Gebiet 22 (NBL) und das zweite Gebiet 32 (PBL) durch Diffusion des ersten Dotierstoffs 20 und des zweiten Dotierstoffs 30 in der epitaktischen Schicht 40 und in dem Trägersubstrat 10 ausbreiten (ausdiffundieren).

Das Auftreten der Dotierstoffdiffusion ist dem Fachmann bekannt und kann bei der Erzeugung der gewünschten Schichtdicken berücksichtigt werden. Zur Verstärkung der Diffusion kann nach dem Einbringen des ersten Dotierstoffs 20 und/oder des zweiten Dotierstoffs 30 eine Erwärmung des Trägersubstrats 10 erfolgen (sog. Drive-In). Weiterhin kann nach dem Aufwachsen der epitaktischen Schicht 40 eine Erwärmung des Trägersubstrats 10 zur Verstärkung der Dotierstoffdiffusion erfolgen. Das Einbringen des ersten Dotierstoffs 20 und/oder des zweiten Dotierstoffs 30 kann über ein Maskenverfahren erfolgen. Zur entsprechenden Strukturdefinition können insbesondere eine erste und eine zweite Maskenschichten ML1 und ML2 verwendet werden. Alternativ kann ein Einbringen der Dotierstoffe jedoch auch über ein maskenloses Strukturierungsverfahren (z. B. direktes lonenstrahlschreiben) erfolgen. Die beiden eingezeichneten Maskenschichten ML1 und ML2 stellen dann entsprechend die jeweiligen Implantationsgebiete dar. Bei dem Trägersubstrat 10 kann es sich vorzugsweise um ein p-Substrat handeln, es können jedoch abhängig von den jeweiligen Anforderungen auch intrinsische oder n-Substrate verwendet werden.

Figur 2 zeigt eine schematische Darstellung einer zweiten Ausführungsform eines Verfahrens zur Bereitstellung tiefliegender n- und p-dotierter Schichten NBL, PBL in einem BCD-Prozess gemäß Stand der Technik. Das Verfahren wird in dieser und den folgenden Darstellungen zur Vereinfachung verkürzt über die erzeugten Strukturen und die jeweilige Maskenabfolge dargestellt, die nicht dargestellten Schritte 1 und 2 aus FIG. 1 sind hierbei jedoch entsprechend mitzulesen. Die in FIG. 2 gezeigte Ausführungsform unterscheidet sich von der in FIG. 1 gezeigten Ausführungsform lediglich dadurch, dass der erste und der zweite Dotierstoff 20 und 30 ein unterschiedliches Diffusionsverhalten im Trägersubstrat 10 und in der epitaktischen Schicht 40 aufweisen. Insbesondere weist der zweite Dotierstoff 30 im zweiten Gebiet 32 (PBL) eine höhere Diffusivität (und damit Diffusionslänge) im Trägersubstrat 10 und in der epitaktischen Schicht 40 auf als der erste Dotierstoff 10 im ersten Gebiet 22 (NBL). Die erzeugten PBL-Schichten haben daher im bereitgestellten BCD-Substrat 100 nach vollständig erfolgter Dotierstoffdiffusion, d. h. nach dem Ausdiffundieren, eine größere Dicke als die erzeugte NBL-Schicht. Das Diffusionsverhalten im Trägersubstrat 10 und in der epitaktischen Schicht 40 hängen unmittelbar von der Auswahl der verwendeten Dotierstoffe 20 und 30 sowie von den jeweils gewählten Parametern (z. B. Dichte, Energie, Fläche, Geometrie) bei Aufbringen ab. Die auftretenden Unterschiede bei den Dicken der erzeugten tiefliegenden n- und p-Schichten NBL und PBL müssen daher beim Design integrierter Schaltungen (z. B. SPADs) entsprechend berücksichtigt werden.

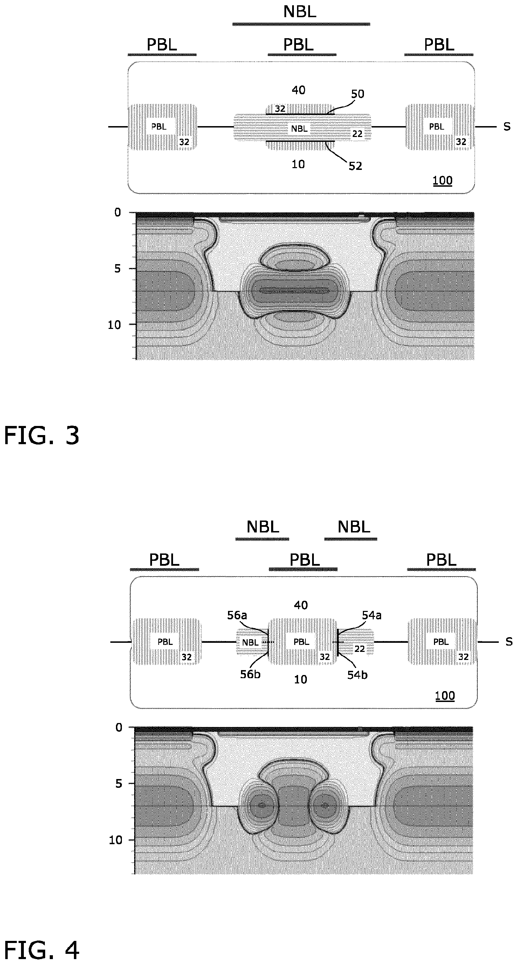

Figur 3 zeigt eine schematische Darstellung einer ersten Ausführungsform ("Saturn") eines erfindungsgemäßen Verfahrens zur Bereitstellung tiefliegender p-n-Übergänge 50 und 52 in einem BCD-Prozess und eine TCAD-Darstellung (engl. "technology computer-aided design, TCAD") der resultierenden Dotierstoffverteilung. Das erfindungsgemäße Verfahren zur Erzeugung tiefliegender p-n-Übergänge 50 und 52 in einem BCD-Prozess umfasst ein Bereitstellen eines Trägersubstrats 10; ein Einbringen eines ersten Dotierstoffs 20 zur Ausbildung eines ersten Gebiets 22 (NBL) vom ersten Leitungstyp (Donator) in eine Oberfläche S des Trägersubstrats 10; ein Einbringen eines zweiten Dotierstoffs 30 zur Ausbildung eines zweiten Gebiets 32 (PBL) vom zweiten Leitungstyp (Akzeptor) in die Oberfläche S des Trägersubstrats 10, wobei sich das erste Gebiet 22 (NBL) und das zweite Gebiet 32 (PBL) zumindest teilweise überlagern; ein Aufwachsen einer epitaktischen Schicht 40 auf die Oberfläche S des Trägersubstrats 10, wobei sich das erste Gebiet 22 (NBL) und das zweite Gebiet 32 (PBL) durch Diffusion des ersten Dotierstoffs 20 und des zweiten Dotierstoffs 30 in der epitaktischen Schicht 40 und in dem Trägersubstrat 10 ausbreiten, wobei das Diffusionsverhalten des ersten und des zweiten Dotierstoffs 20 und 30 derart gewählt sind, dass ersten und der zweite Dotierstoff 20, 30 durch Diffusion jeweils einen in der epitaktischen Schicht 40 und einen in dem Trägersubstrat liegenden p-n-Übergang 50 und 52 ausbilden. In der Darstellung handelt es sich bei dem ersten Gebiet 22 um eine tiefliegende NBL-Schicht und bei dem zweiten Gebiet 32 um eine tiefliegende PBL-Schicht. Die Reihenfolge ist jedoch vertauschbar, so dass es sich bei dem ersten Gebiet 22 auch um eine tiefliegende PBL-Schicht und bei dem zweiten Gebiet 32 entsprechend um eine tiefliegende NBL-Schicht handeln kann. Über eine entsprechende Anpassung der Diffusionslängen der einzelnen Dotierstoffe kann auch die Schichtfolge bei den erzeugten p-n-Übergängen 50 und 52 umgekehrt werden, z. B. könnten in FIG. 3 auch die NBL- und PBL-Schichten an den p-n-Übergängen 50 und 52 vertauscht werden.

Das beschriebene Verfahren unterscheidet sich somit insbesondere dadurch von den beschriebenen Verfahren zur Erzeugung tiefliegender n- und p-dotierter Schichten PBL und NBL in einem BCD-Prozess gemäß Stand der Technik, dass sich das erste Gebiet 22 (NBL) und das zweite Gebiet 32 (PBL) zumindest teilweise überlagern. Vorzugsweise können dabei mindestens zwei in unterschiedlichen Materialbereichen (Trägersubstrat 10, epitaktische Schicht 40) liegende p-n-Übergänge 50 und 52 (d. h. unterschiedliche p-n-Übergangsbereiche) ausgebildet werden. Insbesondere kann unmittelbar nach dem Einbringen des zweiten Dotierstoffs 30 in einer Aufsicht auf die Oberfläche S des Trägersubstrats 10 das erste Gebiet 22 oder das zweite Gebiet 32 vollständig das jeweils anderen Gebiet 32, 22 überlagern. Daher liegt bei der gezeigten Ausführungsform unmittelbar nach dem Einbringen des zweiten Dotierstoffs 30 zur Ausbildung des zweiten Gebiets 32 (PBL) dieses in einer Aufsicht auf die Oberfläche S des Trägersubstrats 10 vollständig im ersten Gebiet 22 (NBL). Um dabei jeweils einen in der epitaktischen Schicht 40 und einen im Trägersubstrat 10 liegenden p-n-Übergang 50, 52 ausbilden zu können, weisen der erste und der zweite Dotierstoff 20, 30 vorzugsweise ein unterschiedliches Diffusionsverhalten im Trägersubstrat 10 und/oder in der epitaktischen Schicht 40 auf. Insbesondere kann der zweite Dotierstoff 30 im zweiten Gebiet 32 (PBL) wie gezeigt eine höhere Diffusivität (und damit Diffusionslänge) im Trägersubstrat 10 und in der epitaktischen Schicht 40 als der erste Dotierstoff 10 im ersten Gebiet 22 (NBL) aufweisen.

Zur Verstärkung der Diffusion kann nach dem Einbringen des ersten Dotierstoffs 20 und/oder des zweiten Dotierstoffs 30 eine Erwärmung des Trägersubstrats 10 erfolgen. Weiterhin kann nach dem Aufwachsen der epitaktischen Schicht 40 eine zusätzliche Erwärmung des Trägersubstrats 10 zur Verstärkung der Dotierstoffdiffusion erfolgen. Ein Einbringen des ersten Dotierstoffs 20 und/oder des zweiten Dotierstoffs 30 kann auch beim erfindungsgemäßen Verfahren sowohl maskenlos oder über ein Maskenverfahren erfolgen. Die gezeigte erste Ausführungsform des erfindungsgemäßen Verfahrens kann als eine vollständige Überlagerung des ersten Gebiets 22 (NBL) mit einem einzelnen zweiten Gebiet 32 (PBL) entsprechend der in FIG. 2 gezeigten Ausführungsform eines Verfahrens gemäß Stand der Technik aufgefasst werden. Im Stand der Technik werden die ersten und zweiten Gebiete 22 und 32 jedoch typischerweise räumlich getrennt voneinander ausgebildet. Insbesondere ist der Abstand d dabei im Allgemeinen mindestens so groß gewählt, dass auch nach dem Ausdiffundieren der einzelnen Dotierstoffe keine sich überlagernden Gebiete erzeugt werden. Daher können über das beschriebene Verfahren gemäß Stand der Technik auch keine tiefliegenden p-n-Übergänge 50 und 52 zwischen den NBL- und PBL-Schichten erzeugt werden.

Die unterhalb der schematischen Darstellung angegebene TCAD-Darstellung zeigt die Dotierstoffverteilung innerhalb des kontaktierten erfindungsgemäßen BCD-Substrats 100 zur Simulation einer entsprechenden integrierten Diodenstruktur. Aufgrund der in dieser Ausführungsform vorhandenen Doppelstruktur mit einem oberen p-n-Übergang 50 und einem unteren p-n-Übergang 52 ergibt sich in der gezeigten Seitenansicht eine effektive Einschnürung des im Bereich der p-n-Übergänge 50 und 52 eingeschlossenen n-Gebiets NBL durch die beiden dieses n-Gebiet NBL umgebenden p-Gebiete PBL. Beide p-n-Übergänge 50 und 52 können mit einer zur Erzeugung eines Lawineneffekts geeigneten Dotierungsdichte und Feldstärkeverteilung ausgebildet werden, wodurch eine besonders dichte Realisierung zweier voneinander unabhängiger tiefliegender SPADs im Bereich der p-n-Übergänge 50 und 52 ermöglicht wird.

Figur 4 zeigt eine schematische Darstellung einer zweiten Ausführungsform ("Donut") eines erfindungsgemäßen Verfahrens zur Bereitstellung tiefliegender p-n-Übergänge 54a, 54b, 56a und 56b in einem BCD-Prozess und eine TCAD-Darstellung der resultierenden Dotierstoffverteilung. Das prinzipielle Verfahren entspricht dem zu FIG. 3 beschriebenen. Die Bezugszeichen und deren Zuordnung zu einzelnen Merkmalen gelten daher entsprechend. Im Unterschied zur FIG. 3 wird unmittelbar nach dem Einbringen des zweiten Dotierstoffs 30 in einer Aufsicht auf die Oberfläche S des Trägersubstrats 10 das zweite Gebiet 32 (PBL) am linken und rechten Randbereich von den Randbereichen zweier erster Gebiete 22 (NBL) überlagert oder berührt. Alternativ kann jedoch auch das erste Gebiet 22 (NBL) am linken und rechten Randbereich von den Randbereichen zweier zweiter Gebiete 32 (PBL) überlagert oder berührt werden. Insbesondere kann unmittelbar nach dem Einbringen des zweiten Dotierstoffs 30 in einer Aufsicht auf die Oberfläche S des Trägersubstrats 10 das erste Gebiet 22 oder das zweite Gebiet 32 auch vollständig im jeweils anderen Gebiet 32 und 22 liegen, jedoch ohne dass sich diese Gebiete 22 und 32 vollständig überlagern. Beispielsweise kann das erste Gebiet 22 das zweite Gebiet 32 (oder anders herum) ring- oder kastenförmig nur in den Randbereichen überlagern oder berühren. Der Begriff "Randbereich" bedeutet dabei, dass neben diesem Randbereich zumindest noch ein überlagerungsfreier "Hauptbereich" existiert.

In der gezeigten Darstellung sind somit zwei erste Gebiete 22 (NBL) und ein die beiden ersten Gebiete 22 (NBL) in den Randbereichen überlagerndes zweites Gebiet 32 (PBL) derart die Oberfläche S des Trägersubstrats 10 eingebracht, dass sich in horizontaler Richtung eine erste rechte p-n-Übergangstruktur, umfassend jeweils zwei in der epitaktischen Schicht 40 liegende p-n-Übergänge 54a und 56a, und eine zweite linke, davon unabhängig geformte p-n-Übergangsstruktur, umfassend jeweils zwei in dem Trägersubstrat 10 liegende p-n-Übergänge 54b und 56b, ergeben. Insofern entspricht diese Ausführungsform im Wesentlichen einer um 90° gedrehten Ausführungsform nach FIG. 3, bei der eine vertikale Anordnung der beiden in FIG. 3 erzeugt p-n-Übergänge 50 und 52 erfolgt. Dies kann auch der zugehörigen TCAD-Darstellung entnommen werden, die ebenfalls eine entsprechend gedrehte Dotierstoffverteilung zeigt. Die p-n-Übergänge 54a und 54b sowie 56a und 56b sind in der Seitenansicht an den durch die beiden randständigen NBL-Schichten erzeugte Einschnürung der zentralen PBL-Schicht zu erkennen.

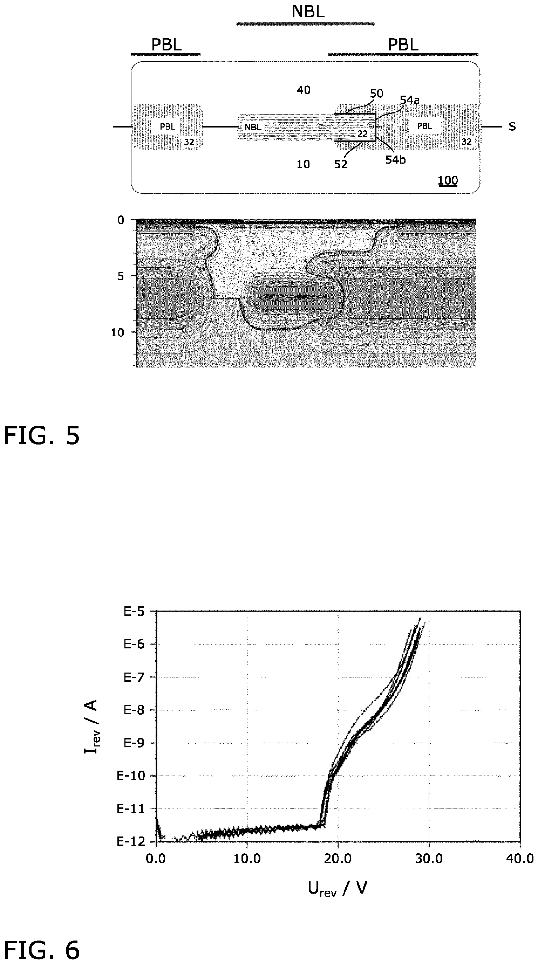

Figur 5 zeigt eine schematische Darstellung einer dritten Ausführungsform ("Pacman") eines erfindungsgemäßen Verfahrens zur Bereitstellung tiefliegender p-n-Übergänge 50, 52, 54a und 54b in einem BCD-Prozess und eine TCAD-Darstellung der resultierenden Dotierstoffverteilung. Das prinzipielle Verfahren entspricht dem zu FIG. 4 beschriebenen. Die Bezugszeichen und deren Zuordnung zu einzelnen Merkmalen gelten daher entsprechend. Im Unterschied zur FIG. 4 überlagern sich unmittelbar nach dem Einbringen des zweiten Dotierstoffs 30 in einer Aufsicht auf die Oberfläche S des Trägersubstrats 10 das erste Gebiet 22 (NBL) und das zweite Gebiet 32 (PBL) nur in den Randbereichen. Ein erstes Gebiet 22 (NBL) und ein zweites Gebiet 32 (PBL) werden somit derart die Oberfläche S des Trägersubstrats 10 eingebracht, dass deren Abstand d nach dem Ausdiffundieren der einzelnen Dotierstoffe negativ wird, d. h. dass ein Teil des einen Gebiets einen Teil des jeweils anderen Gebiets überlagert.

In der schematischen Darstellung ist zu erkennen, dass sich bei dieser Ausführungsform vier zusammenhängende p-n-Übergangsbereiche 50, 52, 54a und 54b ausbilden. Es handelt sich dabei um einen oberen p-n-Übergang 50 in der epitaktischen Schicht, einen unteren p-n-Übergang 52 in dem Trägersubstrat 10 und eine die beiden p-n-Übergänge 50 und 52 verbindende rechte p-n-Übergangsstruktur, umfassend einen in der epitaktischen Schicht 40 liegenden oberen p-n-Übergang 54a und einen in dem Trägersubstrat liegenden unteren p-n-Übergang 54b. In der entsprechenden TCAD-Darstellung sind diese Bereiche an der die zentrale NBL-Schicht an der rechten Seite einschnürenden PBL-Schicht zu erkennen. Die einzelnen p-n-Übergangsbereiche 50, 52, 54a und 54b bilden dabei eine einzige zusammenhängende p-n-Übergangsstruktur aus.

Figur 6 zeigt mehrere Strom-Spannungs-Kennlinien eines in Sperrrichtung Uᵣₑᵥ betriebenen erfindungsgemäßen tiefliegenden p-n-Übergangs erzeugt mit einem erfindungsgemäßen Verfahren entsprechend der ersten Ausführungsform nach FIG. 3 inklusive eines passiven Quenching-Widerstands und ohne Beleuchtung. Der p-n-Übergang weist bei einer Durchbruchspannung U_{BV} (engl. "breakdown voltage, BV") von ca. 18 V einen steil um mehrere Größenordnungen ansteigenden Durchbruchstrom auf. Die Kurvenform ist typisch für einen passiv gequenchten p-n-Übergang einer SPAD mit einer Ausprägung des sogenannten Geiger-Plateaus im Bereich oberhalb der Durchbruchspannung U_{BV} bis ca. 25 V. Die Durchbruchspannung selbst kann allein durch entsprechende Designanpassungen - ohne Prozessanpassung! - variiert werden. Dabei sind beispielsweise Werte von 10 V bis zu 70 V möglich.

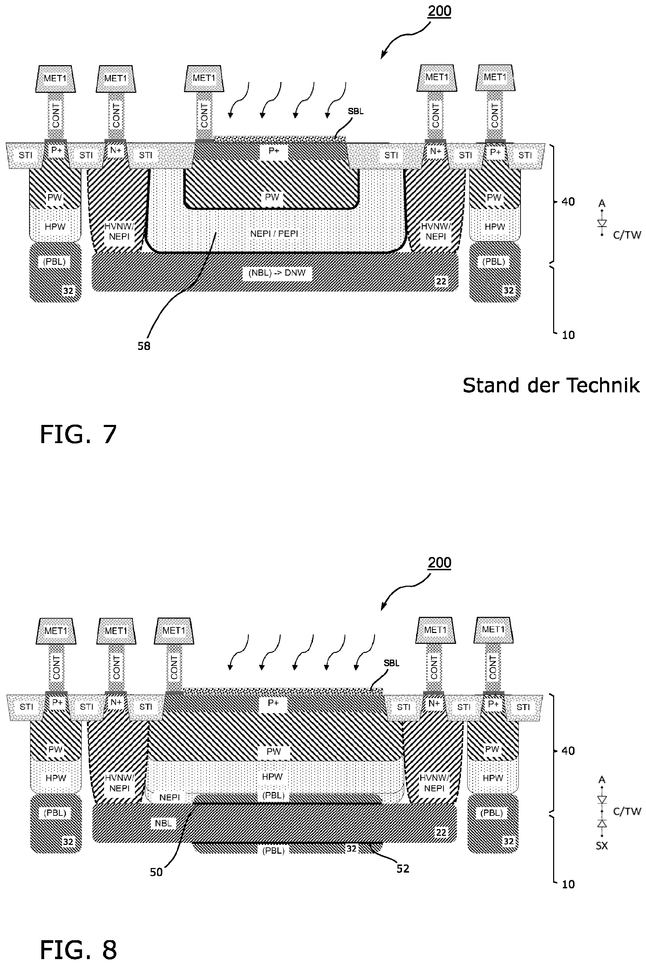

Figur 7 zeigt eine schematische Darstellung einer in BCD-Technologie hergestellten Einzelphotonen-Lawinendiode 200 gemäß Stand der Technik (vgl. Veerappan, Chockalingam, and Edoardo Charbon. "A low dark count pin diode based SPAD in CMOS technology." IEEE transactions on electron devices 63.1 (2015): 65-71 sowie Sanzaro, Mirko, et al. "Single-photon avalanche diodes in a 0.16 µm BCD technology with sharp timing response and red-enhanced sensitivity." IEEE Journal of Selected Topics in Quantum Electronics 24.2 (2017): 1-9). Der Detektor ist hierbei vertikal aufgebaut, wobei die Anode A durch ein p⁺-Gebiet an der Oberfläche des BCD-Substrats 100 und die Kathode C über eine tiefliegende n-Schicht NBL oder eine tiefliegende n-Wanne (engl. "deep n-type well") DNW ausgebildet werden. Dazwischen wird an der Grenze zwischen einer unmittelbar unterhalb des p+-Gebiets angeordneten p-Wanne (engl. "p-type well") PW als Absorptionsgebiet und einem unmittelbar oberhalb der tiefliegenden n-Schicht NBL angeordneten, leicht n- oder p-dotierten, epitaktischen Gebiet (engl. "light n- or p-type epitaxy") NEPI oder PEPI als Leitungsgebiet ein p-n-Übergang 58 ausgebildet. Die p-Wanne PW ist dabei in das leicht n- oder p-dotierte epitaktische Gebiet NEPI oder PEPI von der Oberseite her eingebracht, wodurch die p-Wanne PW auch seitlich vom leicht n- oder p-dotierten epitaktischen Gebiet NEPI oder PEPI umschlossen und somit von umliegenden weiteren Strukturen getrennt wird. Das leicht n- oder p-dotierte epitaktische Gebiet NEPI oder PEPI stellt dabei funktional ein breites intrinsisches Gebiet zur Ausbildung einer p-i-n-Struktur zwischen der p-Wanne PW und der tiefliegenden n-Schicht NBL bzw. der tiefliegenden n-Wanne DNW dar. Die für die gezeigte Einzelphotonen-Lawinendiode 200 relevante p-i-n-Struktur wird somit im Übergangsbereich zwischen der p-Wanne PW, dem leicht n- oder p-dotierten epitaktischen Gebiet NEPI oder PEPI, und der tiefliegenden n-Schicht NBL bzw. der tiefliegenden n-Wanne DNW ausgebildet. Insbesondere kann durch das leicht n- oder p-dotierte epitaktische Gebiet NEPI oder PEPI der Abstand zwischen der p-Wanne PW und den seitlich umliegenden weiteren Strukturen erhöht werden, wodurch ein zwischen diesen Strukturen ausgebildeter parasitärer p-n-Übergang deutlich abgeschwächt wird.

Das verwendete BCD-Substrat 100 kann dabei insbesondere mit einem herkömmlichen Verfahren gemäß der Ausführungsform nach FIG. 2 hergestellt worden sein, wobei auf einem Trägersubstrat 10 nach einer Ausbildung räumlich voneinander getrennter tiefliegender n- und p-Schichten NBL und PBL eine epitaktische Schicht 40 aufgewachsen wurde. Zu den weiteren Einzelheiten des Verfahrens gemäß Stand der Technik wird auf die Beschreibung der FIGs. 1 und 2 verwiesen. Typischerweise wird zum Laufzeitausgleich der unterschiedlichen Lawinenausbreitungsrichtungen und zur Vermeidung von Hot-Spots das Detektorgebiet radial-symmetrisch ausgebildet.

Eine Kontaktierung der vergrabenen Kathode C des Detektors kann über seitlich an das Absorptionsgebiet angrenzende Hochvolt-n-Wannen (engl. "high-voltage n-type well") HVNW und ein darauf angeordnetes n+-Gebiet an der Oberfläche des BCD-Substrats 100 erfolgen. Insbesondere können entsprechende Kontakte CONT über eine Metallisierung MET1 realisiert werden. Die an der Oberfläche liegenden Gebiete können jeweils durch Isolationsgebiete STI voneinander getrennt sein. Das Eintrittsfenster für die zu detektierende Strahlung befindet sich ebenfalls an der Oberfläche des BCD-Substrats 100. Diese kann durch eine aufgebrachte Silizid-Verhinderungsschicht (engl. "silicide blocking layer") SBL geschützt sein. Zur Abschirmung des Detektors gegenüber Substrateinflüssen kann um den Detektor herum ein von der Oberfläche bis in eine tiefliegende p-Schicht PBL reichendes p-Isolationsgebiet angeordnet werden. Das Isolationsgebiet ist für die eigentliche Funktion des Detektors jedoch nicht weiter relevant und wird daher im Folgenden auch nicht näher beschrieben. Das neben der Darstellung gezeigte Ersatzschaltbild verdeutlich aufgrund seiner Position noch einmal die genaue Lage des p-n-Übergangs 58 (p-i-n-Struktur) im BCD-Substrat 100 und gibt die entsprechenden Anschlüsse (Anode A, Kathode/gemeinsame n-Wanne C/TW) an der bereitgestellten Diode an.

Bei der vorgestellten Einzelphotonen-Lawinendiode 200 handelt es sich um eine sogenannte nSPAD mit einem n-seitig im BCD-Substrat 100 angeordneten p-n-Übergang 58 bei der sowohl der Photoneneinfall als auch die Kontaktierung des Detektors von der Oberfläche des BCD-Substrats 100 aus erfolgen. Ein solcher Aufbau ist technologisch recht einfach zu realisieren und aufgrund der möglichen Detektionseigenschaften gegenüber anderen SPAD-Designs bevorzugt. Nachteilig bei einer im Stand der Technik in relativ geringer Tiefe (ca. 2-3 µm im Vergleich zu ca. 5-10 µm in BCD-Technologien mit Epitaxie) über die Oberfläche ohne Epitaxie eingebrachten tiefliegenden n-Schicht NBL bzw. tiefliegenden n-Wanne DNW ist jedoch die dadurch ebenfalls nur relativ geringe Absorptionstiefe für einfallende Photonen, was insbesondere eine Detektion im infraroten Spektralbereich erschwert und die PDE limitiert. Bei einer direkten Übertragung der aus dem Stand der Technik bekannten Strukturen auf BCD-Technologien mit Epitaxieschritt ergeben sich durch die dann vorhandene große Driftstrecke zudem sehr hohe Durchbruchspannungen (V_{BD} >> 30-40 V), welche dann in der Applikation meist schwieriger handzuhaben sind.

Figur 8 zeigt eine schematische Darstellung einer ersten Ausführungsform einer erfindungsgemäßen Einzelphotonen-Lawinendiode 200. Durch ein erfindungsgemäßes Verfahren zur Erzeugung tiefliegender p-n-Übergänge 50, 52, 54a, 54b, und 56a, 56b in einem BCD-Prozess kann der für eine Detektion genutzte p-n-Übergang 50 und 52 auf einfache Art und Weise bedeutend tiefer als im Stand der Technik bereitgestellt werden, wodurch das Absorptionsgebiet und damit die Absorptionstiefe gegenüber den herkömmlichen in BCD-Technologie bereitgestellten SPADs deutlich erhöht werden können.

Alle im Rahmen dieser Anmeldung vorgestellten Ausführungsformen erfindungsgemäßer Einzelphotonen-Lawinendioden 200 sind auf erfindungsgemäßen BCD-Substraten 100 mit einem tiefliegenden p-n-Übergang 50, 52, 54a, 54b, 56a und 56b aufgebaut. Diese umfassen ein Trägersubstrat 10; und eine auf dem Trägersubstrat 10 aufgewachsene epitaktische Schicht 40, wobei zwischen dem Trägersubstrat 10 und der epitaktischen Schicht 40 durch ein erfindungsgemäßes Verfahren gemäß dem im Beschreibungsteil beschriebenen ersten Aspekt oder durch eine Diffusion von in eine Oberfläche S des Trägersubstrats 10 unterhalb der epitaktischen Schicht 40 eingebrachten Dotierstoffen ein in der epitaktischen Schicht 50 liegender p-n-Übergang 50, 52, 54a, 54b, 56a und 56b (z. B. mit einem erfindungsgemäßen Verfahren) erzeugt wurde. Eine erfindungsgemäße Einzelphotonen-Lawinendiode 200 umfasst daher ein erfindungsgemäßes BCD-Substrat 100, wobei ein Bereich um einen p-n-Übergang 50, 52 (optional einzeln oder zusammen mit 54a, 54b und/oder 56a und 56b) ein Lawinengebiet ausbildet, und ein Absorptionsgebiet (PW, HPW) zur Umwandlung von Photonen in Elektronen-Lochpaare, wobei sich das Absorptionsgebiet (PW, HPW) unmittelbar an die den p-n-Übergang 50, 52 (54a, 54b und/oder 56a, 56b) ausbildendem Gebiete (NBL, PBL) anschließt.

Insbesondere ist bei der gezeigten erfindungsgemäßen Einzelphotonen-Lawinendiode 200 der obere p-n-Übergang 50 zumindest teilweise zwischen einer tiefliegenden n-Schicht NBL als Kathode C und einer sich unmittelbar an die tiefliegende n-Schicht NBL anschließenden tiefliegenden p-Schicht PBL ausgebildet, das Absorptionsgebiet (PW, HPW) unmittelbar an die tiefliegende p-Schicht PBL anschließend und als p-Gebiet ausgebildet, und eine als p+-Gebiet ausgebildete Anode A unmittelbar anschließend an das Absorptionsgebiet (PW, HPW) ausgebildet. Das Absorptionsgebiet (PW, HPW) umfasst dabei bevorzugt eine sich unmittelbar an die tiefliegende p-Schicht PBL anschließende Hochvolt-p-Wanne HPW und optional eine sich unmittelbar daran anschließende p-Wanne PW.

Der gezeigte Detektoraufbau entspricht somit weitgehend dem in FIG. 7 gezeigten Aufbau. Die Bezugszeichen und deren Zuordnung zu einzelnen Merkmalen gelten daher entsprechend. Im Unterschied zur FIG. 7 wird der p-n-Übergang 50 am Detektor jedoch bei dieser Ausführungsform unmittelbar durch eine erfindungsgemäße Überlagerung je einer tiefliegenden n- und p-Schicht NBL, PBL und damit deutlich tiefer im BCD-Substrat 100 ausgebildet. Anstatt eines leicht n-dotierten, epitaktischen Gebiets NEPI ist unterhalb der p-Wanne PW als Absorptionsgebiet eine Hochvolt-n-Wannen als erweitertes Absorptionsgebiet ausgebildet. Um die PBL-Schicht oberhalb des p-n-Übergangs 50 kann ein leicht n-dotiertes, epitaktisches Gebiet NEPI angeordnet sein. Der Prozessablauf bei der Herstellung einer entsprechenden erfindungsgemäßen Einzelphotonen-Lawinendiode 200 unterscheidet sich somit nur geringfügig von demjenigen der in FIG. 7 beschriebenen Einzelphotonen-Lawinendiode 200 gemäß Stand der Technik. Das vorteilhafte nSPAD-Design kann daher weitestgehend übernommen werden, ohne dass Anpassungen am prinzipiellen Detektoraufbau erforderlich sind. Die Verwendung eines erfindungsgemäßen BCD-Substrats 100 mit einem tiefliegenden p-n-Übergang 50 (bzw. zwei parallel zur Oberfläche des Trägersubstrats 10 tiefliegenden p-n-Übergängen 50, 52) ermöglicht somit eine einfache Erhöhung der Absorptionstiefe und somit der Empfindlichkeit des bereitgestellten Detektors.

Ein weiterer Vorteil der Verwendung des gezeigten erfindungsgemäßen BCD-Substrats 100 ist die mögliche Bereitstellung und Nutzung eines unabhängigen zweiten p-n-Übergangs 52 an der Unterseite der tiefliegenden n-Schicht NBL. Dieser ermöglicht insbesondere die Verwendung einer zweiten nSPAD an der Unterseite des Trägersubstrats 10. Die zweite nSPAD kann beispielsweise durch die seitliche Kontaktierung der PBL-Gebiete und des p-Substrats mit der Anode auf der Oberseite des BCD-Substrats adressiert und ausgelesen werden. Dies ermöglicht zum einen eine kompakte 3D-Integration von mehreren Detektorelementen, zum anderen lassen sich dadurch wesentliche Verbesserungen bei den Detektionseigenschaften erreichen sowie neue Anwendungsfelder erschließen. Ein von zwei Seiten empfindlicher integrierter Einzelphotonendetektor kann beispielsweise Photonenströme aus entgegengesetzten Richtungen detektieren und somit Abweichungen zwischen den Photonenflüssen feststellen. Zudem kann die zweite SPAD auch als Referenzdetektor zur Reduzierung des Detektorrauschens der ersten SPAD aufgrund von Umgebungseinflüssen (z. B. kosmische Strahlung) eingesetzt werden. Das entsprechende Ersatzschaltbild zeigt somit ebenfalls zwei gegeneinander geschaltete Dioden in Sperrrichtung zwischen einer Anode A und einer Kathode/gemeinsame n-Wanne C/TX. Der Anodenanschluss der unteren Diode wird dabei auch als gemeinsames Substrat SX bezeichnet.

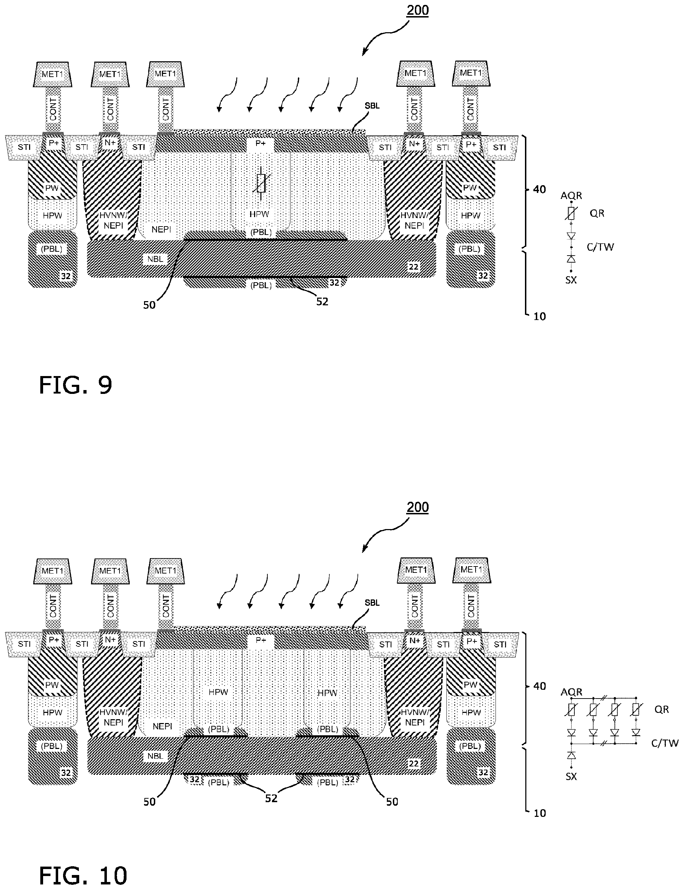

Figur 9 zeigt eine schematische Darstellung einer zweiten Ausführungsform einer erfindungsgemäßen Einzelphotonen-Lawinendiode 200. Der gezeigte Detektoraufbau entspricht dabei weitgehend dem in FIG. 8 gezeigten Aufbau. Die Bezugszeichen und deren Zuordnung zu einzelnen Merkmalen gelten daher entsprechend. Im Unterschied zur FIG. 8 ist das entsprechende Absorptionsgebiet (NEPI) zwischen der tiefliegenden p-Schicht PBL und der Anode A vollständig als leicht n-dotiertes, epitaktisches Gebiet NEPI mit einer als Kanal ausgebildeten Hochvolt-p-Wanne HPW als vollständig integrierter Quenching-Widerstand QR ausgebildet. Der Quenching-Widerstand QR weist vorzugsweise eine nicht-lineare Widerstandsfunktion auf. Nach dem Auslösen einer Ladungslawine durch eine photoneninduzierte Ladungsträgererzeugung im Absorptionsgebiet (NEPI) kommt es am Quenching-Widerstand QR zu einem Spannungsabfall, welcher eine weitere Ladungsträgererzeugung durch Stoßionisation verhindert und somit die Ladungsträgerlawine löscht. Im Detektor kann sich dann mit Verzögerung erneut eine Sperrspannung aufbauen bevor eine erneute Ladungslawine ausgelöst werden kann.

Die Integration des Quenching-Widerstand QR als Kanal in ein leicht n-dotiertes, epitaktisches Gebiet NEPI kann prozesstechnologisch recht einfach realisiert werden und ermöglicht über die Ausbildung als Hochvolt-p-Wanne HPW eine flexible Anpassung des gewünschten Widerstandsverhaltens. Durch eine unmittelbare Integration kann der Füllfaktor auf dem BCD-Substrat 100 erhöht werden. Im Ersatzschaltbild ist der Quenching-Widerstand QR oberhalb der internen Anode der Diode eingezeichnet. Der obere Anschluss AQR kann zusätzlich mit einem weiteren aktiven oder passiven Quenching-Widerstand verbunden sein.

Figur 10 zeigt eine schematische Darstellung einer dritten Ausführungsform einer erfindungsgemäßen Einzelphotonen-Lawinendiode 200. Der gezeigte Detektoraufbau entspricht dabei weitgehend dem in FIG. 9 gezeigten Aufbau. Die Bezugszeichen und deren Zuordnung zu einzelnen Merkmalen gelten daher entsprechend. Im Unterschied zur FIG. 9 ist entlang der tiefliegenden n-Schicht NBL eine Vielzahl von unmittelbar oberhalb der tiefliegenden n-Schicht NBL separat angeordneten tiefliegenden p-Schichten PBL ausgebildet. Dies ermöglicht eine Nebeneinanderanordnung einer Vielzahl von voneinander unabhängigen Einzelphotonen-Lawinendioden 200 durch welche bei entsprechendem Parallelbetrieb die effektive Detektortotzeit weitestgehend vollständig umgangen werden kann. Beispielsweise können mit bestehender BCD-Technologie bis zu sieben Einzelphotonen-Lawinendioden 200 in einem typischerweise ca. 20 µm breiten Pixel eines herkömmlichen SPAD-Arrays angeordnet werden. Im entsprechenden Ersatzschaltbild ist diese Schaltung als Parallelschaltung einer Vielzahl von Einzelphotonen-Lawinendioden 200 gemäß der Ausführungsform nach FIG. 9 dargestellt.

Auch bei den Ausführungsformen nach FIG. 9 und 10 können die im BCD-Substrat 100 entsprechend bereitgestellten unteren p-n-Übergange wie zu FIG. 8 bereits beschrieben zur Ausbildung von weiteren Einzelphotonen-Lawinendioden 200 genutzt werden. In diesem Fall könnten mit bestehender BCD-Technologie durch diese Doppelanordnung übereinander sogar aktuell bis zu vierzehn Einzelphotonen-Lawinendioden 200 in einem einzigen 20 µm breiten Pixel eines herkömmlichen SPAD-Arrays angeordnet werden. Durch Verbesserungen bei der verwendeten BCD-Technologie ist davon auszugehen, dass sich die Anzahl der innerhalb eines solchen Pixels anordenbaren Einzelphotonen-Lawinendioden 200 zukünftig noch einmal deutlich erhöhen lässt. Die deutlich erhöhte Integrationsdichte kann beispielsweise zur weiteren Steigerung der PDE oder zur Verminderung der Fehlerrate bei der Detektion genutzt werden.

### Bezugszeichenliste

- 10: Trägersubstrat
- 20: erster Dotierstoff
- 22: erstes Gebiet
- 30: zweiter Dotierstoff
- 32: zweites Gebiet
- 40: epitaktische Schicht
- 50, 52: p-n-Übergang ("oben", "unten")
- 54a, 54b: p-n-Übergang ("rechts oben", "rechts unten")
- 56a, 56b: p-n-Übergang ("links oben", "links unten")
- 58: p-n-Übergang (Stand der Technik)
- 100: BCD-Substrat
- 200: Einzelphotonen-Lawinendiode (SPAD)

- NBL: tiefliegende n-Schicht (engl. "n-type buried layer")
- PBL: tiefliegende p-Schicht (engl. "p-type buried layer")
- ML1, ML2: erste und zweite Maskenschicht
- H(V)PW: Hochvolt-p-Wanne (engl. "high-voltage p-type well")
- H(V)NW: Hochvolt-n-Wanne (engl. "high-voltage n-type well")
- PW: p-Wanne (engl. "p-type well")
- NW: n-Wanne (engl. "p-type well")
- DPW: tiefliegende p-Wanne (engl. "deep p-type well")
- DNW: tiefliegende n-Wanne (engl. "deep n-type well")
- NEPI: leicht n-dotiertes, epitaktisches Gebiet (engl. "light n-type epitaxy")
- PEPI: leicht p-dotiertes, epitaktisches Gebiet (engl. "light p-type epitaxy")
- MET1: Metallisierung
- CONT: Kontakt
- SBL: Silizid-Verhinderungsschicht (engl. "silicide blocking layer")
- STI: Isolationsgebiet (engl. "shallow trench isolation")
- P⁺: p⁺-Gebiet
- N⁺: n⁺-Gebiet

- A: Anode
- C: Kathode
- TW: gemeinsame n-Wanne (engl. "twin-well")
- SX: Bulkgebiet oder gemeinsames Substrat
- QR: Quenching-Widerstand (engl. "quenching resistor")
- AQR: anodenseitiges Terminal hinter dem Quenching-Widerstand
- S: Oberfläche
- d: Abstand

## Patentansprüche

1. Verfahren zur Erzeugung tiefliegender p-n-Übergänge (50, 52, 54a, 54b, 56a, 56b) in einem BCD-Prozess, umfassend:
- Bereitstellen eines Trägersubstrats (10);
- Einbringen eines ersten Dotierstoffs (20) zur Ausbildung eines ersten Gebiets (22) vom ersten Leitungstyp in eine Oberfläche (S) des Trägersubstrats (10);
- Aufwachsen einer epitaktischen Schicht (40) auf die Oberfläche (S) des Trägersubstrats (10), wobei sich das erste Gebiet (22) durch Diffusion des ersten Dotierstoffs (20) in der epitaktischen Schicht (40) und in dem Trägersubstrat (10) ausbreitet;
- Einbringen eines zweiten Dotierstoffs (30) zur Ausbildung eines zweiten Gebiets (32) vom zweiten Leitungstyp in einen Bereich des ersten Gebiets (22), wobei sich das erste Gebiet (22) und das zweite Gebiet (32) zumindest teilweise überlagern, und das Einbringen des zweiten Dotierstoffs (20, 30) derart gewählt ist, dass der erste und zweite Dotierstoff (20, 30) durch das Einbringen einen in der epitaktischen Schicht (40) liegenden p-n-Übergang (50, 52, 54a, 54b, 56a, 56b) ausbilden.

2. Verfahren zur Erzeugung tiefliegender p-n-Übergänge (50, 52, 54a, 54b, 56a, 56b) in einem BCD-Prozess, umfassend:
- Bereitstellen eines Trägersubstrats (10);
- Einbringen eines ersten Dotierstoffs (20) zur Ausbildung eines ersten Gebiets (22) vom ersten Leitungstyp in eine Oberfläche (S) des Trägersubstrats (10);
- Einbringen eines zweiten Dotierstoffs (30) zur Ausbildung eines zweiten Gebiets (32) vom zweiten Leitungstyp in die Oberfläche (S) des Trägersubstrats (10), wobei sich das erste Gebiet (22) und das zweite Gebiet (32) zumindest teilweise überlagern;
- Aufwachsen einer epitaktischen Schicht (40) auf die Oberfläche (S) des Trägersubstrats (10), wobei sich das erste Gebiet (22) und das zweite Gebiet (32) durch Diffusion des ersten Dotierstoffs (20) und des zweiten Dotierstoffs (30) in der epitaktischen Schicht (40) und in dem Trägersubstrat (10) ausbreiten, wobei das Diffusionsverhalten des ersten und des zweiten Dotierstoffs (20, 30) derart gewählt sind, dass der erste und zweite Dotierstoff (20, 30) durch Diffusion einen in der epitaktischen Schicht (40) liegenden p-n-Übergang (50, 52, 54a, 54b, 56a, 56b) ausbilden.

3. Verfahren nach Anspruch 1 oder 2, wobei der erste und zweite Dotierstoff (20, 30) durch das Einbringen und/oder durch Diffusion jeweils einen in der epitaktischen Schicht (40) und einen in dem Trägersubstrat (10) liegenden p-n-Übergang (50, 52, 54a, 54b, 56a, 56b) ausbilden.

4. Verfahren nach einem der Ansprüche 1 bis 3, wobei der erste und der zweite Dotierstoff (20, 30) ein unterschiedliches Diffusionsverhalten im Trägersubstrat (10) und/oder in der epitaktischen Schicht (40) aufweisen.

5. Verfahren nach einem der Ansprüche 1 bis 4, wobei der zweite Dotierstoff (30) eine höhere Diffusivität im Trägersubstrat (10) und/oder in der epitaktischen Schicht (40) aufweist als der erste Dotierstoff (20).

6. Verfahren nach einem der vorhergehenden Ansprüche, wobei nach dem Einbringen des ersten Dotierstoffs (20) und/oder des zweiten Dotierstoffs (30) eine Erwärmung des Trägersubstrats (10) zur Verstärkung der Diffusion erfolgt, und/oder wobei nach dem Aufwachsen der epitaktischen Schicht (40) eine Erwärmung des Trägersubstrats (10) zur Verstärkung der Dotierstoffdiffusion erfolgt.

7. Verfahren nach einem der vorhergehenden Ansprüche, wobei das Einbringen des ersten Dotierstoffs (20) und/oder des zweiten Dotierstoffs (30) maskenlos oder über ein Maskenverfahren erfolgt.

8. Verfahren nach einem der Ansprüche 1 bis 7, wobei unmittelbar nach dem Einbringen des zweiten Dotierstoffs (30) in einer Aufsicht auf die Oberfläche (S) des Trägersubstrats (10) das erste Gebiet (22) oder das zweite Gebiet (32) vollständig das jeweils anderen Gebiet (32, 22) überlagert, oder sich das erste Gebiet (22) und das zweite Gebiet (32) nur in den Randbereichen überlagern.

9. Verfahren nach einem der Ansprüche 1 bis 7, wobei unmittelbar nach dem Einbringen des zweiten Dotierstoffs (30) in einer Aufsicht auf die Oberfläche (S) des Trägersubstrats (10) das erste Gebiet (22) an einem linken und rechten Randbereich von den Randbereichen zweier zweiter Gebiete (32) überlagert wird, oder das zweite Gebiet (32) an einem linken und rechten Randbereich von den Randbereichen zweier erster Gebiete (22) überlagert wird.

10. Verfahren nach einem der vorhergehenden Ansprüche, wobei es sich bei dem ersten Gebiet (22) um eine tiefliegende n-Schicht (NBL) und bei dem zweiten Gebiet (32) um eine tiefliegende p-Schicht (PBL) handelt.

11. BCD-Substrat (100) mit einem tiefliegenden p-n-Übergang (50, 52, 54a, 54b, 56a, 56b), umfassend:
ein Trägersubstrat (10); und
eine auf dem Trägersubstrat (10) aufgewachsene epitaktische Schicht (40), wobei zwischen dem Trägersubstrat (10) und der epitaktischen Schicht (40) durch ein Verfahren nach Anspruch 1 oder durch eine Diffusion von in eine Oberfläche (S) des Trägersubstrats (10) unterhalb der epitaktischen Schicht (40) eingebrachten Dotierstoffen ein in der epitaktischen Schicht liegender p-n-Übergang (50, 52, 54a, 54b, 56a, 56b) erzeugt wurde.

12. BCD-Substrat (100) nach Anspruch 11, wobei jeweils ein in der epitaktischen Schicht (40) und ein in dem Trägersubstrat (10) liegender p-n-Übergang (50, 52, 54a, 54b, 56a, 56b) erzeugt wurde.

13. Einzelphotonen-Lawinendiode (200), SPAD, umfassend:
ein BCD-Substrat (100) nach Anspruch 11 oder 12, wobei ein Bereich um einen p-n-Übergang (50, 52, 54a, 54b, 56a, 56b) ein Lawinengebiet ausbildet, und
ein Absorptionsgebiet (PW, HPW, NEPI) zur Umwandlung von Photonen in Elektronen-Lochpaare, wobei sich das Absorptionsgebiet (PW, HPW, NEPI) unmittelbar an die den p-n-Übergang (50, 52, 54a, 54b, 56a, 56b) ausbildenden Gebiete (NBL, PBL) anschließt.

14. Einzelphotonen-Lawinendiode (200) nach Anspruch 13, wobei
der p-n-Übergang (50, 52, 54a, 54b, 56a, 56b) zumindest teilweise zwischen einer tiefliegenden n-Schicht (NBL) als Kathode (C) und einer sich unmittelbar an die tiefliegende n-Schicht (NBL) anschließenden tiefliegenden p-Schicht (PBL) ausgebildet ist,
das Absorptionsgebiet (PW, HPW, NEPI) sich unmittelbar an die tiefliegende p-Schicht (PBL) anschließt und als p-Gebiet ausgebildet ist, und
eine als p+-Gebiet ausgebildete Anode (A) sich unmittelbar an das Absorptionsgebiet (PW, HPW, NEPI) anschließt.

15. Einzelphotonen-Lawinendiode (200) nach Anspruch 14, wobei das Absorptionsgebiet (PW, HPW, NEPI) eine sich unmittelbar an die tiefliegende p-Schicht (PBL) anschließende Hochvolt-p-Wanne (HPW) und optional ein sich unmittelbar daran anschließende p-Wanne (PW) umfasst.

16. Einzelphotonen-Lawinendiode (200) nach Anspruch 14 oder 15, wobei das Absorptionsgebiet (PW, HPW, NEPI) zwischen der tiefliegenden p-Schicht (PBL) und der Anode (A) als leicht n-dotiertes, epitaktisches Gebiet (NEPI) mit einer als Kanal ausgebildeten Hochvolt-p-Wanne (HPW) als nicht-linearer Quenching-Widerstand (QR) ausgebildet ist.

17. Einzelphotonen-Lawinendiode (200) nach Anspruch 16, wobei entlang der tiefliegenden n-Schicht (NBL) eine Vielzahl von unmittelbar oberhalb der tiefliegenden n-Schicht (NBL) angeordneten separaten tiefliegenden p-Schichten (PBL) ausgebildet ist.

18. Integrierte Schaltung, umfassend mindestens eine Einzelphotonen-Lawinendiode (200) nach einem der Ansprüchen 13 bis 17.
